# EUROPEAN PATENT APPLICATION

(11) **EP 4 456 697 A1**
(43) Date of publication of application: **30.10.2024**
(21) Application number: 24166257.6
(22) Date of filing: 26.03.2024
(51) Int. Cl.: H10K 59/12, H10K 59/122, H10K 59/80, H10K 71/16, H10K 71/40

(54) **DISPLAY PANEL AND METHOD OF MANUFACTURING THE SAME**

(30) Priority: 27.04.2023 KR 20230055711
(71) Applicant: Samsung Display Co., Ltd., Yongin-si, Gyeonggi-do 17113 (KR)
(72) Inventor: PARK, Joonyong, Yongin-si (KR); SHIN, Hyuneok, Yongin-si (KR); YANG, Sukyoung, Yongin-si (KR); LEE, Dongmin, Yongin-si (KR)
(74) Representative: Marks & Clerk LLP

(57) **Abstract**

A display panel includes a base layer, a pixel definition layer disposed on the base layer and provided with a light emitting opening defined therethrough, a barrier wall disposed on the pixel definition layer, having a conductivity, and provided with a barrier wall opening defined therethrough to correspond to the light emitting opening, and a light emitting element disposed in the light emitting opening and including an anode, an intermediate layer disposed on the anode, and a cathode disposed on the intermediate layer and connected to the barrier wall. The anode includes a conductive layer and a protective layer including first, second, and third layers disposed on the conductive layer and sequentially stacked. The second layer has an amorphous structure, and the third layer has a polycrystalline structure.

## Description

### BACKGROUND

### 1. Field

The present disclosure relates to a display panel and a method of manufacturing the same. More particularly, the present disclosure relates to a display panel with improved display quality and a method of manufacturing the display panel.

### 2. Description of the Related Art

Display devices that provide images to a user, such as a television set, a monitor, a smart phone, and a tablet computer, include a display panel to display the images. Various types of display panels, such as a liquid crystal display panel, an organic light emitting display panel, an electrowetting display panel, and an electrophoretic display panel, are being developed.

The organic light emitting display panel includes an anode, a cathode, and a light emitting pattern. The light emitting pattern is disposed in each light emitting area after being divided into plural portions, and the cathode provides a common voltage to each light emitting area.

### SUMMARY

The present disclosure provides a display panel with improved display quality and including a light emitting element formed without a metal mask.

The present disclosure provides a method of manufacturing the display panel.

Embodiments of the invention provide a display panel including a base layer, a pixel definition layer disposed on the base layer and provided with a light emitting opening defined therethrough, a barrier wall disposed on the pixel definition layer, having a conductivity, and provided with a barrier wall opening defined therethrough to correspond to the light emitting opening, and a light emitting element disposed in the light emitting opening and including an anode, an intermediate layer disposed on the anode, and a cathode disposed on the intermediate layer and connected to the barrier wall. The anode includes a conductive layer and a protective layer including first, second, and third layers disposed on the conductive layer and sequentially stacked. The second layer has an amorphous structure, and the third layer has a polycrystalline structure.

In an embodiment, the second layer includes zinc indium tin oxide.

In an embodiment, the second layer includes at least one of indium zinc oxide and indium gallium zinc oxide.

In an embodiment, the anode further includes a lower protective layer that is in contact with a rear surface of the conductive layer, wherein the conductive layer includes silver (Ag), and the lower protective layer includes indium tin oxide (ITO).

In an embodiment, the display panel further includes a sacrificial pattern disposed on the protective layer and provided with a sacrificial opening defined therethrough to correspond to the light emitting opening.

In an embodiment, the first layer has the polycrystalline structure.

In an embodiment, the first layer and the third layer include indium tin oxide (ITO).

In an embodiment, the first layer has a thickness smaller than a thickness of the third layer.

In an embodiment, a thickness of the first layer is equal to or greater than about 70 angstroms and equal to or smaller than about 115 angstroms, the second layer has a thickness equal to or greater than about 100 angstroms and equal to or smaller than about 500 angstroms, and the third layer has a thickness equal to or greater than about 100 angstroms and equal to or smaller than about 700 angstroms.

In an embodiment, the second layer is in contact with the intermediate layer.

In an embodiment, the second layer includes a hole injection layer.

In an embodiment, the barrier wall has an undercut shape when viewed in a cross-section, and the cathode is in contact with the barrier wall.

Embodiments of the invention provide a display panel including a base layer, a pixel definition layer disposed on the base layer and provided with a light emitting opening defined therethrough, a barrier wall disposed on the pixel definition layer, having a conductivity, provided with a barrier wall opening defined therethrough to overlap the light emitting opening, and having an undercut shape, and a light emitting element including an anode disposed in the barrier wall opening, a cathode disposed above the anode and connected to the barrier wall, and an intermediate layer disposed between the anode and the cathode and including a light emitting layer. At least a portion of the anode is covered by the pixel definition layer. The anode includes a conductive layer, a first protective layer disposed on the conductive layer and having an amorphous structure, and a second protective layer disposed on the first protective layer and having a polycrystalline structure.

In an embodiment, the first protective layer includes indium tin oxide (ITO), and the second protective layer includes zinc indium tin oxide (ZITO).

In an embodiment, the first protective layer has a thickness equal to or greater than about 100 angstroms and equal to or smaller than about 500 angstroms, and the second protective layer has a thickness equal to or greater than about 100 angstroms and equal to or smaller than about 700 angstroms.

Embodiments of the invention provide a method of manufacturing a display panel. The method includes forming a preliminary anode pattern including a conductive layer and a protective layer including first, second, and third layers sequentially disposed on the conductive layer and having an amorphous structure, heat treating the preliminary anode pattern to form an anode pattern, forming an insulating layer, patterning the insulating layer to form a pixel definition layer through which a plurality of light emitting openings is formed to expose at least a portion of the anode pattern, forming a conductive layer on the pixel definition layer, and forming a barrier wall opening corresponding to the light emitting opening through the conductive layer to form a barrier wall having an undercut shape. The second layer of the preliminary anode pattern has a same crystalline structure as a second layer of the anode pattern in the heat treating of the preliminary anode pattern to form the anode pattern.

In an embodiment, the heat treating of the preliminary anode pattern is carried out within a temperature range equal to or greater than about 200 degrees Celsius and equal to or smaller than about 260 degrees Celsius.

In an embodiment, the first and third layers of the anode pattern have a polycrystalline structure.

In an embodiment, a gas containing argon (Ar) and hydrogen (H₂) is used in the forming of the third layer of the protective layer.

In an embodiment, the forming of the barrier wall includes forming a first conductive layer on the pixel definition layer, forming a second conductive layer on the first conductive layer, first etching the first and second conductive layers to form a first pattern, and second etching the first pattern to form an undercut shape in the first pattern.

In an embodiment, a first etchant used in the first etching is different from a second etchant used in the second etching.

In an embodiment, the method further includes forming an intermediate layer including a light emitting material and a cathode that is in contact with the barrier wall in the barrier wall opening.

According to the above, in an embodiment, the damage on the conductive layer of the anode caused by the etchant is prevented.

According to the above, in an embodiment, as the conductive layer of the anode is prevented from being damaged, deterioration in the display quality of the display panel is prevented.

According to the above, in an embodiment, the number of processes carried out to form the pattern after depositing the anode is reduced.

According to the above, in an embodiment, as the number of processes carried out to form the pattern after depositing the anode is reduced, a process efficiency is improved, and a cost of manufacture is reduced.

At least some of the above and other features of the invention are set out in the claims.

### BRIEF DESCRIPTION OF THE DRAWINGS

The above and other advantages of the invention will become readily apparent by reference to the following detailed description when considered in conjunction with the accompanying drawings wherein:
FIG. 1A is a perspective view of a display device, according to an embodiment;
FIG. 1B is an exploded perspective view of a display device, according to an embodiment;
FIG. 2 is a cross-sectional view of a display module, according to an embodiment;
FIG. 3 is a schematic plan view of a display panel, according to an embodiment;
FIG. 4 is an equivalent schematic circuit diagram of a pixel, according to an embodiment;
FIG. 5 is an enlarged plan view of a portion of a display panel, according to an embodiment;
FIG. 6 is a cross-sectional view of a portion of a display panel, according to an embodiment;
FIG. 7A is an enlarged cross-sectional view of a portion of a display panel, according to an embodiment;
FIG. 7B is an enlarged cross-sectional view of a portion of a display panel, according to an embodiment;
FIG. 8 is a cross-sectional view of a display panel, according to an embodiment;
FIG. 9A is a cross-sectional view illustrating a method of manufacturing a display panel, according to an embodiment;
FIG. 9B is a cross-sectional view illustrating a method of manufacturing a display panel, according to an embodiment;
FIG. 9C is a cross-sectional view illustrating a method of manufacturing a display panel, according to an embodiment;
FIG. 9D is a cross-sectional view illustrating a method of manufacturing a display panel, according to an embodiment;
FIG. 9E is a cross-sectional view illustrating a method of manufacturing a display panel, according to an embodiment;
FIG. 9F is a cross-sectional view illustrating a method of manufacturing a display panel, according to an embodiment;
FIG. 9G is a cross-sectional view illustrating a method of manufacturing a display panel, according to an embodiment;
FIG. 9H is a cross-sectional view illustrating a method of manufacturing a display panel, according to an embodiment;
FIG. 9I is a cross-sectional view illustrating a method of manufacturing a display panel, according to an embodiment;
FIG. 9J is a cross-sectional view illustrating a method of manufacturing a display panel, according to an embodiment;
FIG. 9K is a cross-sectional view illustrating a method of manufacturing a display panel, according to an embodiment;
FIG. 9L is a cross-sectional view illustrating a method of manufacturing a display panel, according to an embodiment;
FIG. 9M is a cross-sectional view illustrating a method of manufacturing a display panel, according to an embodiment; and
FIG. 10 is a cross-sectional view of a portion of a display panel, according to an embodiment.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

In the present disclosure, it will be understood that when an element (or area, layer, or portion) is referred to as being related to another element such as being "on", "connected to" or "coupled to" another element or layer, it can be directly on, connected or coupled to the other element or layer and/or intervening elements or layers may be present. For example, being "disposed directly on" may mean that two layers or two members are disposed without using an additional member such as an adhesive member, therebetween.

Like numerals refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms including technical and scientific terms used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, a display panel and a method of manufacturing the display panel according to embodiments of the invention will be described with reference to the accompanying drawings.

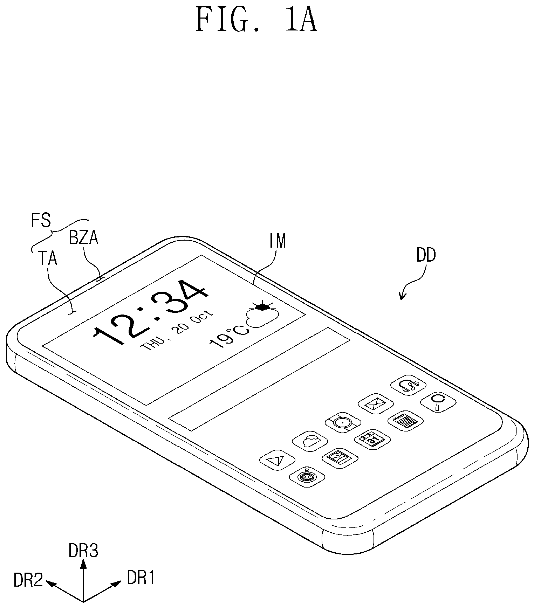

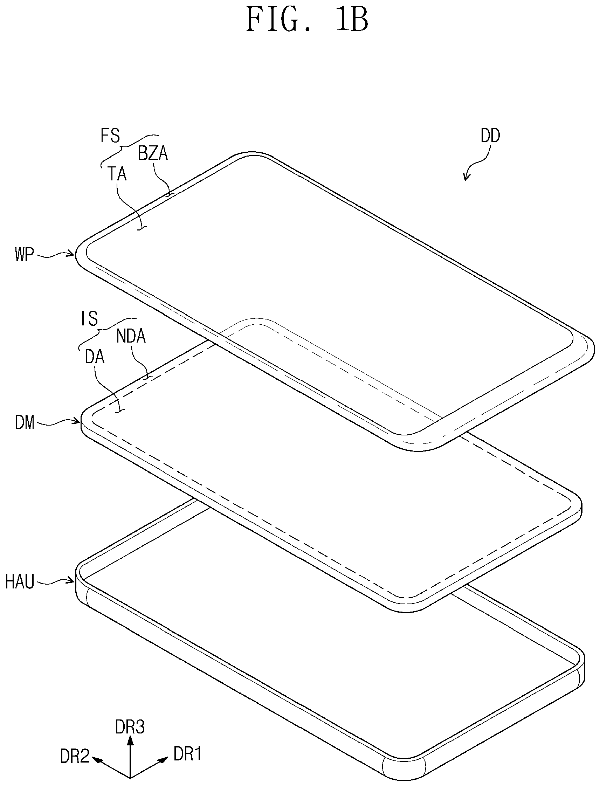

FIG. 1A is a perspective view of a display device DD according to an embodiment, and FIG. 1B is an exploded perspective view of the display device DD according to an embodiment.

In an embodiment, the display device DD may be applied to a large-sized electronic item, such as a television set, a monitor, and/or an outdoor billboard. In addition, the display device DD may be applied to a small and medium-sized electronic item, such as a personal computer, a notebook computer, a personal digital assistant, a car navigation unit, a game unit, a smartphone, a tablet computer, and/or a camera. However, these are merely examples, and the display device DD may be employed in other electronic items. In an embodiment, the smartphone will be described as a representative example of the display device DD.

In an embodiment and referring to FIGS. 1A and 1B, the display device DD may display an image IM through a display surface FS, which is substantially parallel to each of a first direction DR1 and a second direction DR2, toward a third direction DR3. The image IM may include a video and/or a still image. FIG. 1A shows a clock widget and application icons as a representative example of the image IM. The display surface FS through which the image IM is displayed may correspond to a front surface of the display device DD.

In an embodiment, front (or upper) and rear (or lower) surfaces of each member of the display device DD may be defined with respect to a direction in which the image IM is displayed. The front and rear surfaces may be directed opposite to each other in the third direction DR3, and a normal line direction of each of the front and rear surfaces may be substantially parallel to the third direction DR3. Meanwhile, directions indicated by the first, second, and third directions DR1, DR2, and DR3, respectively, may be relative to each other and may be changed to other directions. In the following descriptions, the expression "when viewed in a plane" means a state of being viewed in the third direction DR3.

In an embodiment, the display device DD may include a window WP, a display module DM, and a housing HAU. The window WP and the housing HAU may be coupled to each other to provide an exterior of the display device DD.

In an embodiment, the window WP may include an optically transparent insulating material. For example, the window WP may include a glass or plastic material. A front surface of the window WP may define the display surface FS of the display device DD. The display surface FS may include a transmissive area TA and a bezel area BZA. The transmissive area TA may be an optically transparent area. As an example, the transmissive area TA may be an area having a visible light transmittance of about 90% or more.

In an embodiment, the bezel area BZA may be an area having a relatively lower transmittance than that of the transmissive area TA. The bezel area BZA may define a shape of the transmissive area TA. The bezel area BZA may be disposed adjacent to the transmissive area TA and may surround the transmissive area TA. However, this is merely an example, and the bezel area BZA may be omitted from the window WP. The window WP may include at least one functional layer of an anti-fingerprint layer, a hard coating layer, and an anti-reflective layer and should not be particularly limited.

In an embodiment, the display module DM may be disposed under the window WP. The display module DM may have a configuration that substantially generates the image IM. The image IM generated by the display module DM may be displayed through a display surface IS of the display module DM and may be viewed by a user through the transmissive area TA.

In an embodiment, the display module DM may include a display area DA and a non-display area NDA. The display area DA may be activated in response to electrical signals. The non-display area NDA may be located adjacent to the display area DA. The non-display area NDA may surround the display area DA. The non-display area NDA may be covered by the bezel area BZA and may not be viewed from the outside.

In an embodiment, the housing HAU may be coupled with the window WP. The housing HAU and the window WP, which are coupled to each other, may provide a predetermined inner space. The display module DM may be accommodated in the inner space.

In an embodiment, the housing HAU may include a material with a relatively high rigidity. As an example, the housing HAU may include a frame and/or a plate formed of glass, plastic, metal material, and/or any combinations thereof. The housing HAU may stably protect the components of the display device DD accommodated in the inner space from external impacts.

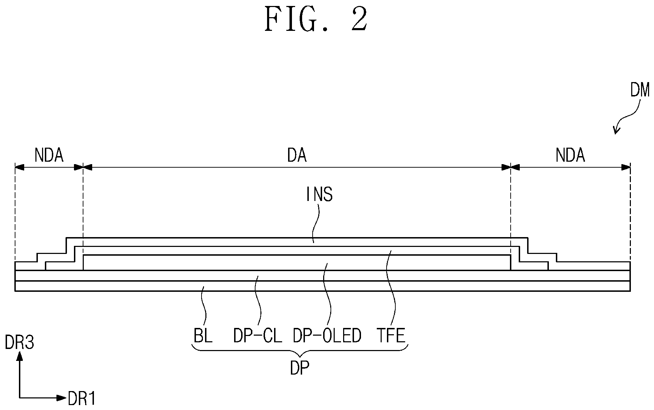

FIG. 2 is a cross-sectional view of the display module DM according to an embodiment.

In an embodiment and referring to FIG. 2, the display module DM may include a display panel DP and an input sensor INS. Although not shown in figures, the display device DD (refer to FIG. 1A) may include a protective member disposed on a lower surface of the display panel DP and/or an anti-reflective member and/or a window member disposed on an upper surface of the input sensor INS.

In an embodiment, the display panel DP may be a light emitting type display panel, however, it should not be particularly limited. For example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot, a quantum rod, and/or a micro-LED. Hereinafter, the organic light emitting display panel will be described as the display panel DP.

In an embodiment, the display panel DP may include a base layer BL, a circuit element layer DP-CL, a display element layer DP-OLED, and a thin film encapsulation layer TFE. The circuit element layer DP-CL, the display element layer DP-OLED, and the thin film encapsulation layer TFE may be disposed on the base layer BL. The input sensor INS may be disposed directly on the thin film encapsulation layer TFE. In the present disclosure, the expression "A component A is disposed directly on a component B." means that no adhesive layers are present between the component A and the component B.

In an embodiment, the base layer BL may include at least one plastic film. The base layer BL may be a flexible substrate and may include a plastic substrate, a glass substrate, a metal substrate, or an organic/inorganic composite material substrate. The display area DA and the non-display area NDA described with reference to FIG. 1B may be defined equally in the base layer BL.

In an embodiment, the circuit element layer DP-CL may include at least one insulating layer and a circuit element. The insulating layer may include at least one inorganic layer and at least one organic layer. The circuit element may include signal lines and a pixel driving circuit.

In an embodiment, the display element layer DP-OLED may include a barrier wall and a light emitting element. The light emitting element may include an anode, an intermediate layer, and a cathode.

In an embodiment, the thin film encapsulation layer TFE may include a plurality of thin layers. Some thin layers may be disposed to improve an optical efficiency, and some thin layers may be disposed to protect organic light emitting diodes.

In an embodiment, the input sensor INS may obtain coordinate information of an external input. The input sensor INS may have a multi-layer structure. The input sensor INS may include a conductive layer having a single-layer or multi-layer structure. The input sensor INS may include an insulating layer having a single-layer or multi-layer structure. The input sensor INS may sense the external input by a capacitive method, however, the invention should not be limited thereto or thereby. As an example, the input sensor INS may sense the external input by an electromagnetic induction method and/or a pressure sensing method. Meanwhile, according to an embodiment, the input sensor INS may be omitted.

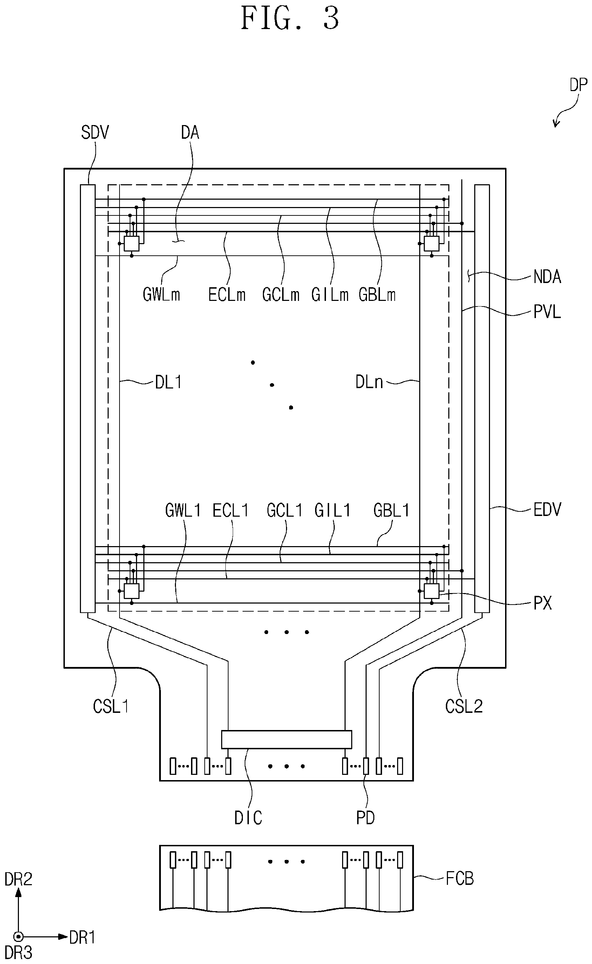

FIG. 3 is a plan view of the display panel DP according to an embodiment.

In an embodiment and referring to FIG. 3, the display panel DP may include the display area DA and the non-display area NDA around the display area DA. The display area DA and the non-display area NDA may be distinguished from each other by a presence or absence of pixels PX. The pixels PX may be disposed in the display area DA. A scan driver

SDV, a data driver, and an emission driver EDV may be disposed in the non-display area NDA. The data driver may be a circuit provided in a driving chip DIC.

In an embodiment, the display panel DP may include the pixels PX, a plurality of initialization scan lines GIL1 to GILm, a plurality of compensation scan lines GCL1 to GCLm, a plurality of write scan lines GWL1 to GWLm, a plurality of black scan lines GBL1 to GBLm, a plurality of emission control lines ECL1 to ECLm, a plurality of data lines DL1 to DLn, first and second control lines CSL1 and CSL2, a driving voltage line PVL, and a plurality of pads PD. In an embodiment, each of the "m" and the "n" may be a natural number equal to or greater than 2.

In an embodiment, the pixels PX may be connected to the initialization scan lines GIL1 to GILm, the compensation scan lines GCL1 to GCLm, the write scan lines GWL1 to GWLm, the black scan lines GBL1 to GBLm, the emission control lines ECL1 to ECLm, and the data lines DL1 to DLn.

In an embodiment, the initialization scan lines GIL1 to GILm, the compensation scan lines GCL1 to GCLm, the write scan lines GWL1 to GWLm, and the black scan lines GBL1 to GBLm may extend in a direction parallel and opposite to the first direction DR1 and may be electrically connected to the scan driver SDV. The data lines DL1 to DLn may extend in a direction parallel and opposite to the second direction DR2 and may be electrically connected to the driving chip DIC. The emission control lines ECL1 to ECLm may extend in the first direction DR1 and may be electrically connected to the emission driver EDV.

In an embodiment, the driving voltage line PVL may include a portion extending in the first direction DR1 and a portion extending in the second direction DR2. The portion extending in the first direction DR1 and the portion extending in the second direction DR2 may be disposed on different layers from each other. The driving voltage line PVL may provide a driving voltage to the pixels PX.

In an embodiment, the first control line CSL1 may be connected to the scan driver SDV. The second control line CSL2 may be connected to the emission driver EDV.

In an embodiment, the driving chip DIC, the driving voltage line PVL, the first control line CSL1, and the second control line CSL2 may be electrically connected to the pads PD. A flexible circuit film FCB may be electrically connected to the pads PD through an anisotropic conductive adhesive layer. The pads PD may connect the flexible circuit film FCB to the display panel DP. The pads PD may be connected to corresponding pixels PX through the driving voltage line PVL, the first control line CSL1, and the second control line CSL2.

In addition, in an embodiment, the pads PD may further include input pads. The input pads may connect the flexible circuit film FCB to the input sensor INS (refer to FIG. 2), however, the invention should not be limited thereto or thereby. According to an embodiment, the input pads may be disposed in the input sensor INS and may be connected to a circuit board different from the circuit board to which the pads PD are connected. According to an embodiment, the input sensor INS may be omitted, and the pads PD may not further include the input pads.

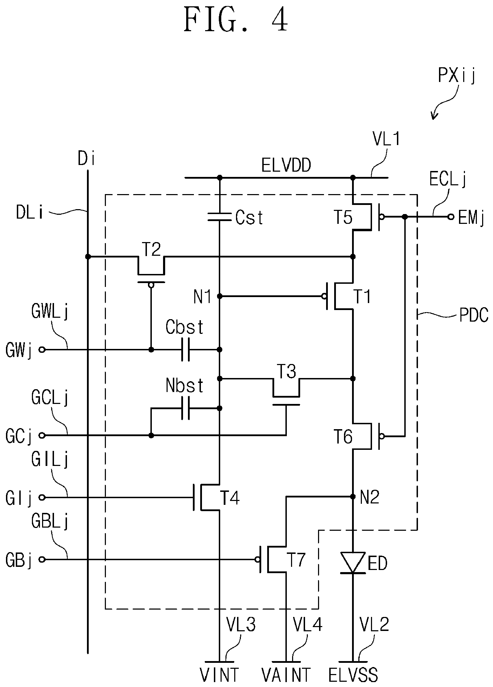

FIG. 4 is an equivalent schematic circuit diagram of a pixel PXij according to an embodiment.

FIG. 4 shows an embodiment of an equivalent circuit diagram of the pixel PXij among the pixels PX of FIG. 3. Since the pixels PX have substantially the same configuration as each other, the circuit configuration of the pixel PXij will be described in detail, and detailed descriptions of the other pixels will be omitted.

In an embodiment and referring to FIGS. 3 and 4, the pixel PXij may be connected to an i-th data line DLi among the data lines DL1 to DLn, a j-th initialization scan line GILj among the initialization scan lines GIL1 to GILm, a j-th compensation scan line GCLj among the compensation scan lines GCL1 to GCLm, a j-th write scan line GWLj among the write scan lines GWL1 to GWLm, a j-th black scan line GBLj among the black scan lines GBL1 to GBLm, a j-th emission control line ECLj among the emission control lines ECL1 to ECLm, first and second driving voltage lines VL1 and VL2, and first and second initialization voltage lines VL3 and VL4. The "i" may be an integer number equal to or greater than 1 and equal to or smaller than n, and the " j" may be an integer number equal to or greater than 1 and equal to or smaller than m.

In an embodiment, the pixel PXij may include a light emitting element ED and a pixel circuit PDC. The light emitting element ED may be a light emitting diode. As an example, the light emitting element ED may be an organic light emitting diode including an organic light emitting layer, however, it should not be particularly limited. The pixel circuit PDC may control an amount of current flowing through the light emitting element ED in response to an i-th data signal Di. The light emitting element ED may emit a light with a predetermined luminance corresponding to the amount of current provided from the pixel circuit PDC.

In an embodiment, the pixel circuit PDC may include first, second, third, fourth, fifth, sixth, and seventh transistors T1, T2, T3, T4, T5, T6, and T7, respectively, and first, second, and third capacitors Cst, Cbst, and Nbst, respectively. The configuration of the pixel circuit PDC should not be limited to the embodiment shown in FIG. 4. The pixel circuit PDC shown in FIG. 4 is merely an example, and the configuration of the pixel circuit PDC may be changed.

In an embodiment, at least one of the first to seventh transistors T1 to T7, respectively, may include a low-temperature polycrystalline silicon (LTPS) as its semiconductor layer. At least one of the first to seventh transistors T1 to T7, respectively, may include an oxide material as its semiconductor layer. As an example, each of the third and fourth transistors T3 and T4, respectively, may be an oxide semiconductor transistor, and each of the first, second, fifth, sixth, and seventh transistors T1, T2, T5, T6, and T7, respectively, may be a low-temperature polycrystalline silicon (LTPS) transistor.

In detail, in an embodiment, the first transistor T1, which directly affects a luminance of the light emitting element ED, may include the semiconductor layer containing polycrystalline silicon with high reliability, and thus, the display device with high resolution may be implemented. Meanwhile, since the oxide semiconductor has a high carrier mobility and a low leakage current, the voltage drop is not large even though the driving time is long. That is, even when the pixel circuit PDC is driven at low frequency, a change in color of the image due to the voltage drop is not large, and thus, the pixel circuit PDC may be driven at low frequency. As described above, since the oxide semiconductor has low leakage current, at least one of the third transistor T3 and the fourth transistor T4, which are connected to a gate electrode of the first transistor T1, may include the oxide semiconductor. Thus, the leakage current may be prevented from flowing to the gate electrode of the first transistor T1, and power consumption may be reduced.

In an embodiment, some of the first to seventh transistors T1 to T7, respectively, may be a P-type transistor, and the other of the first to seventh transistors T1 to T7, respectively, may be an N-type transistor. As an example, each of the first, second, fifth, sixth, and seventh transistors T1, T2, T5, T6, and T7, respectively, may be the P-type transistor, and each of the third and fourth transistors T3 and T4, respectively, may be the N-type transistor.

The configuration of the pixel circuit PDC should not be limited to that shown in FIG. 4. The pixel circuit PDC shown in FIG. 4 is merely an example, and the configuration of the pixel circuit PDC may be changed. As an example, in an embodiment, all the first to seventh transistors T1 to T7, respectively, may be the P-type transistor or the N-type transistor. According to an embodiment, the first, second, fifth, and sixth transistors T1, T2, T5, and T6, respectively, may be the P-type transistor, and the third, fourth, and seventh transistors T3, T4, and T7, respectively, may be the N-type transistor.

In an embodiment, the j-th initialization scan line GILj, the j-th compensation scan line GCLj, the j-th write scan line GWLj, the j-th black scan line GBLj, and the j-th emission control line ECLj may transmit a j-th initialization scan signal GIj, a j-th compensation scan signal GCj, a j-th write scan signal GWj, a j-th black scan signal GBj, and a j-th emission control signal EMj to the pixel PXij, respectively. The i-th data line DLi may transmit an i-th data signal Di to the pixel PXij. The i-th data signal Di may have a voltage level corresponding to the image signal input to the display device DD (refer to FIG. 1A).

In an embodiment, the first and second driving voltage lines VL1 and VL2 may transmit a first driving voltage ELVDD and a second driving voltage ELVSS to the pixel PXij, respectively. In addition, the first and second initialization voltage lines VL3 and VL4 may transmit a first initialization voltage VINT and a second initialization voltage VAINT to the pixel PXij, respectively.

In an embodiment, the first transistor T1 may be connected between the first driving voltage line VL1 receiving the first driving voltage ELVDD and the light emitting element ED. The first transistor T1 may include a first electrode connected to the first driving voltage line VL1 via the fifth transistor T5, a second electrode electrically connected to a pixel electrode (or referred to as the anode) of the light emitting element ED via the sixth transistor T6, and a third electrode (e.g., the gate electrode) connected to one end (e.g., a first node N1) of the first capacitor Cst. The first transistor T1 may receive the i-th data signal Di transmitted by the i-th data line DLi in response to a switching operation of the second transistor T2 and may supply a driving current to the light emitting element ED.

In an embodiment, the second transistor T2 may be connected between the i-th data line DLi and the first electrode of the first transistor T1. The second transistor T2 may include a first electrode connected to the i-th data line DLi, a second electrode connected to the first electrode of the first transistor T1, and a third electrode (e.g., a gate electrode) connected to the j-th write scan line GWLj. The second transistor T2 may be turned on in response to the j-th write scan signal GWj applied thereto via the j-th write scan line GWLj and may transmit the i-th data signal Di applied thereto via the i-th data line DLi to the first electrode of the first transistor T1. One end of the second capacitor Cbst may be connected to the third electrode of the second transistor T2, and the other end of the second capacitor Cbst may be connected to the first node N1.

In an embodiment, the third transistor T3 may be connected between the second electrode of the first transistor T1 and the first node N1. The third transistor T3 may include a first electrode connected to the third electrode of the first transistor T1, a second electrode connected to the second electrode of the first transistor T1, and a third electrode (e.g., a gate electrode) connected to the j-th compensation scan line GCLj. The third transistor T3 may be turned on in response to the j-th compensation scan signal GCj applied thereto via the j-th compensation scan line GCLj and may connect the third electrode and the second electrode of the first transistor T1 to each other to allow the first transistor T1 to be connected in a diode configuration. One end of the third capacitor Nbst may be connected to the third electrode of the third transistor T3, and the other end of the third capacitor Nbst may be connected to the first node N1.

In an embodiment, the fourth transistor T4 may be connected between the first initialization voltage line VL3 to which the first initialization voltage VINT is applied and the first node N1. The fourth transistor T4 may include a first electrode connected to the first initialization voltage line VL3 to which the first initialization voltage VINT is applied, a second electrode connected to the first node N1, and a third electrode (e.g., a gate electrode) connected to the j-th initialization scan line GILj. The fourth transistor T4 may be turned on in response to the j-th initialization scan signal GIj applied thereto via the j-th initialization scan line GILj. The turned-on fourth transistor T4 may transmit the first initialization voltage VINT to the first node N1 to initialize an electric potential of the third electrode of the first transistor T1, i.e., an electric potential of the first node N1.

In an embodiment, the fifth transistor T5 may include a first electrode connected to the first driving voltage line VL1, a second electrode connected to the first electrode of the first transistor T1, and a third electrode (e.g., a gate electrode) connected to the j-th emission control line ECLj. The sixth transistor T6 may include a first electrode connected to the second electrode of the first transistor T1, a second electrode connected to the pixel electrode of the light emitting element ED, and a third electrode (e.g., a gate electrode) connected to the j-th emission control line ECLj.

In an embodiment, the fifth transistor T5 and the sixth transistor T6 may be substantially simultaneously turned on in response to the j-th emission control signal EMj applied thereto via the j-th emission control line ECLj. The first driving voltage ELVDD applied via the turned-on fifth transistor T5 may be compensated for by the first transistor T1 connected in the diode configuration and may be transmitted to the light emitting element ED via the sixth transistor T6.

In an embodiment, the seventh transistor T7 may include a first electrode connected to the second initialization voltage line VL4 to which the second initialization voltage VAINT is applied, a second electrode connected to the second electrode of the sixth transistor T6, and a third electrode (e.g., a gate electrode) connected to the j-th black scan line GBLj. The second initialization voltage VAINT may have a voltage level equal to or lower than that of the first initialization voltage VINT.

In an embodiment, the one end of the first capacitor Cst may be connected to the third electrode of the first transistor T1, and the other end of the first capacitor Cst may be connected to the first driving voltage line VL1. The cathode of the light emitting element ED may be connected to the second driving voltage line VL2 that transmits the second driving voltage ELVSS. The second driving voltage ELVSS may have a voltage level lower than that of the first driving voltage ELVDD.

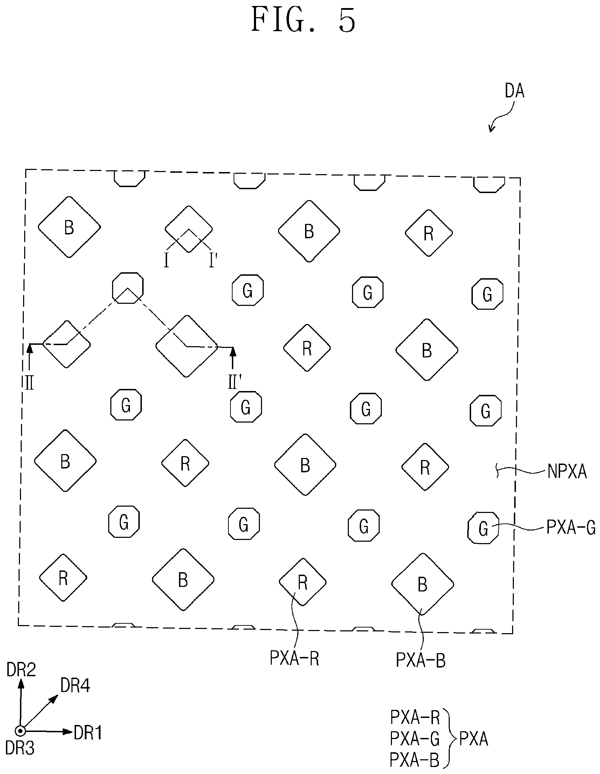

FIG. 5 is an enlarged plan view of a portion of the display area DA of the display panel according to an embodiment. FIG. 5 is a plan view showing an embodiment of the display module DM (see FIG. 1B) when viewed from an upper side of the display surface IS (see FIG. 1B) of the display module DM (see FIG. 1B) and shows an arrangement of light emitting areas PXA-R, PXA-G, and PXA-B.

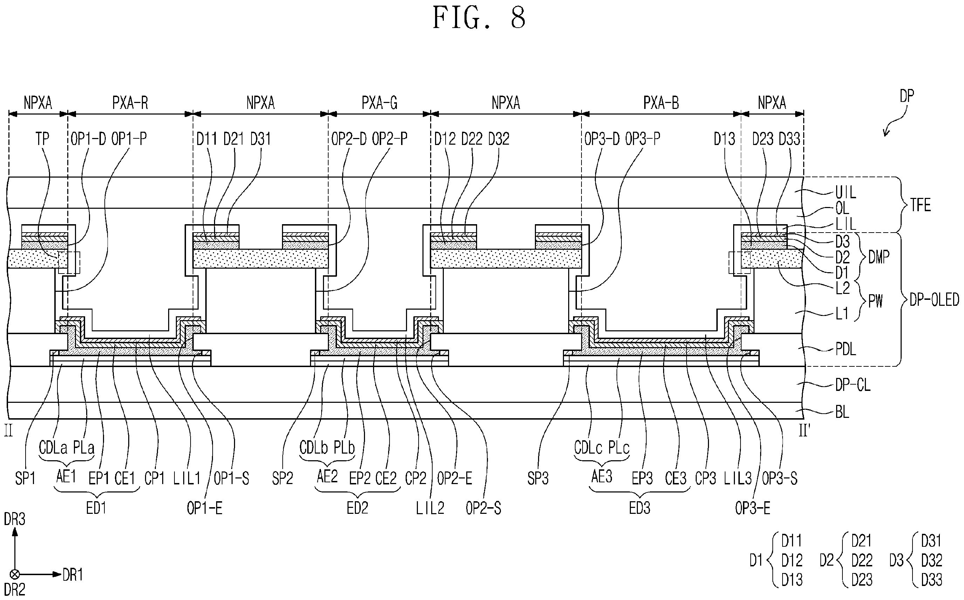

In an embodiment and referring to FIG. 5, the display area DA may include first, second, and third light emitting areas PXA-R, PXA-G, and PXA-B, respectively, and a peripheral area NPXA surrounding the first, second, and third light emitting areas PXA-R, PXA-G, and PXA-B, respectively. The first, second, and third light emitting areas PXA-R, PXA-G, and PXA-B, respectively, may respectively correspond to areas from which lights provided from light emitting elements ED1, ED2, and ED3 (refer to FIG. 8) are emitted. The first, second, and third light emitting areas PXA-R, PXA-G, and PXA-B, respectively, may be distinguished by colors of the lights emitted outward from the display module DM (refer to FIG. 2).

In an embodiment, the first, second, and third light emitting areas PXA-R, PXA-G, and PXA-B, respectively, may respectively provide first, second, and third color lights having colors different from each other. As an example, the first color light may be a red light, the second color light may be a green light, and the third color light may be a blue light. However, the first, second, and third color lights should not be limited thereto or thereby.

In an embodiment, each of the first, second, and third light emitting areas PXA-R, PXA-G, and PXA-B, respectively, may be defined as an area through which an upper surface of the anode is exposed by a light emitting opening described later. The peripheral area NPXA may define a boundary between the first, second, and third light emitting areas PXA-R, PXA-G, and PXA-B, respectively, and may prevent a mixture of the colors of the lights traveling between the first, second, and third light emitting areas PXA-R, PXA-G, and PXA-B, respectively.

In an embodiment, each of the first, second, and third light emitting areas PXA-R, PXA-G, and PXA-B, respectively, may be provided in plural and may be repeatedly arranged in a predetermined arrangement within the display area DA. As an example, the first and third light emitting areas PXA-R and PXA-B, respectively, may be alternately arranged with each other in the first direction DR1 to form a first group. The second light emitting areas PXA-G may be arranged in the first direction DR1 to form a second group. Each of the first group and the second group may be provided in plural, and the first groups may be alternately arranged with the second groups in the second direction DR2.

In an embodiment, one second light emitting area PXA-G may be disposed to be spaced apart from one first light emitting area PXA-R or one third light emitting area PXA-B in a fourth direction DR4. The fourth direction DR4 may correspond to a direction between the first and second directions DR1 and DR2, respectively.

Meanwhile, in an embodiment, FIG. 5 shows an example of an arrangement of the first, second, and third light emitting areas PXA-R, PXA-G, and PXA-B, respectively, however, the invention should not be particularly limited, and the arrangement of the first, second, and third light emitting areas PXA-R, PXA-G, and PXA-B, respectively, may be changed in various ways. The first, second, and third light emitting areas PXA-R, PXA-G, and PXA-B, respectively, may be arranged in a pentile pattern (PENTILE^{™}) as shown in FIG. 5. According to an embodiment, the first, second, and third light emitting areas PXA-R, PXA-G, and PXA-B, respectively, may be arranged in a stripe pattern or a diamond pattern (Diamond Pixel^{™}).

In an embodiment, each of the first, second, and third light emitting areas PXA-R, PXA-G, and PXA-B, respectively, may have a variety of shapes when viewed in a plane. As an example, each of the first, second, and third light emitting areas PXA-R, PXA-G, and PXA-B, respectively, may have a polygonal shape, a circular shape, or an oval shape. In FIG. 5, the first and third light emitting areas PXA-R and PXA-B, respectively, each having a quadrangular shape or a lozenge shape and the second light emitting area PXA-G having an octagonal shape are shown as a representative example.

In an embodiment, the first, second, and third light emitting areas PXA-R, PXA-G, and PXA-B, respectively, may have substantially the same shape as each other when viewed in the plane, or at least one of the first, second, and third light emitting areas PXA-R, PXA-G, and PXA-B, respectively, may have a shape different from the others. FIG. 5 shows a structure in which the first and third light emitting areas PXA-R and PXA-B, respectively, have the same shape as each other when viewed in the plane and the second light emitting area PXA-G has a shape that is different from those of the first and third light emitting areas PXA-R and PXA-B, respectively, as a representative example.

In an embodiment, at least one of the first, second, and third light emitting areas PXA-R, PXA-G, and PXA-B, respectively, may have a size that is different from those of the others when viewed in the plane. The size of the first light emitting area PXA-R emitting the red light may be greater than the size of the second light emitting area PXA-G emitting the green light and may be smaller than the size of the third light emitting area PXA-B emitting the blue light. However, a size relationship between the first, second, and third light emitting areas PXA-R, PXA-G, and PXA-B, respectively, according to the colors of the lights should not be limited thereto or thereby and may be changed in various ways depending on a design of the display module DM (refer to FIG. 2). In addition, according to an embodiment, the first, second, and third light emitting areas PXA-R, PXA-G, and PXA-B, respectively, may have substantially the same size as each other when viewed in the plane.

Meanwhile, in an embodiment, the shape, size, and arrangement of the first, second, and third light emitting areas PXA-R, PXA-G, and PXA-B, respectively, of the display module DM (refer to FIG. 2) may be designed in various ways depending on the colors of the emitted lights, the size of the display module DM (refer to FIG. 2), and/or the configuration of the display module DM (refer to FIG. 2), and they should not be limited to the embodiment shown in FIG. 5.

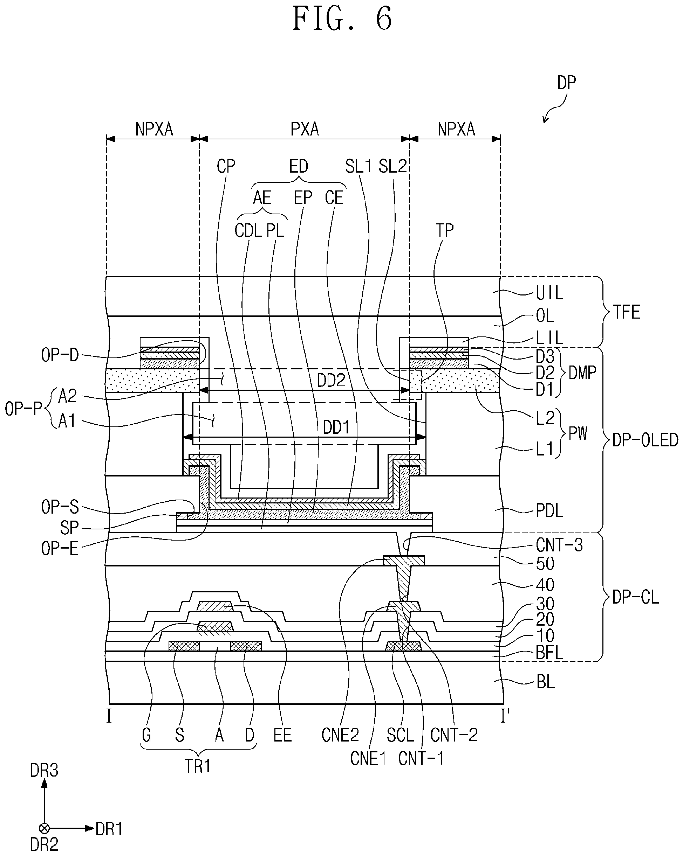

FIG. 6 is a cross-sectional view of a portion of the display panel DP according to an embodiment. FIG. 6 is a cross-sectional view of the display panel DP taken along a line I-I' of FIG. 5 according to an embodiment. In FIG. 6, the same reference numerals denote the same elements in FIG. 5, and thus, details of the same elements will be omitted.

In an embodiment, FIG. 6 is an enlarged cross-sectional view of the portion of the light emitting area, e.g., the first light emitting area PXA-R (refer to FIG. 5), of the light emitting area PXA (refer to FIG. 5) of the display area DA (refer to FIG. 5). The light emitting area PXA of FIG. 6 should not be limited to the first light emitting area PXA-R (refer to FIG. 5) and may correspond to one of the second light emitting area PXA-G (refer to FIG. 5) and the third light emitting areas PXA-B (refer to FIG. 5).

In an embodiment and referring to FIG. 6, the display panel DP may include the base layer BL, the circuit element layer DP-CL, the display element layer DP-OLED, and the thin film encapsulation layer TFE.

In an embodiment, the display panel DP may include a plurality of insulating layers, a semiconductor pattern, a conductive pattern, and a signal line. An insulating layer, a semiconductor layer, and a conductive layer may be formed by a coating or depositing process. Then, the insulating layer, the semiconductor layer, and the conductive layer may be selectively patterned by a photolithography process and an etching process. The semiconductor pattern, the conductive pattern, and the signal line, which are included in the circuit element layer CL and the display element layer DP-OLED, may be formed through the above processes.

In an embodiment, the circuit element layer DP-CL may be disposed on the base layer BL. The circuit element layer DP-CL may include a buffer layer BFL, a transistor TR1, a signal transmission area SCL, first, second, third, fourth, and fifth insulating layers 10, 20, 30, 40, and 50, respectively, an electrode EE, and a plurality of connection electrodes CNE1 and CNE2.

In an embodiment, the buffer layer BFL may be disposed on the base layer BL. The buffer layer BFL may increase an adhesion between the base layer BL and the semiconductor pattern. The buffer layer BFL may include a silicon oxide layer and a silicon nitride layer, and the silicon oxide layer and the silicon nitride layer may be alternately stacked with each other.

In an embodiment, the semiconductor pattern may be disposed on the buffer layer BFL. The semiconductor pattern may include polysilicon, however, it should not be limited thereto or thereby. The semiconductor pattern may include an amorphous silicon or metal oxide. FIG. 6 shows a portion of the semiconductor pattern, and the semiconductor pattern may be further disposed in the light emitting areas PXA-R, PXA-G, and PXA-B (refer to FIG. 5). The semiconductor pattern may be arranged with a specific rule over the light emitting areas PXA-R, PXA-G, and PXA-B (refer to FIG. 5). The semiconductor pattern may have different electrical properties depending on whether it is doped or not or whether it is doped with an N-type dopant or a P-type dopant. The semiconductor pattern may include a first region having a relatively high doping concentration and a second region having a relatively low doping concentration. The first region may be doped with the N-type dopant or the P-type dopant. A P-type transistor may include the first region doped with the P-type dopant.

In an embodiment, the first region may have a conductivity greater than that of the second region and may substantially serve as an electrode or a signal line. The second region may substantially correspond to an active (or a channel) of the transistor. In other words, a portion of the semiconductor pattern may be the active of the transistor, another portion of the semiconductor pattern may be a source or a drain of the transistor, and the other portion of the semiconductor pattern may be a conductive area.

In an embodiment, a source S, an active A, and a drain D of the transistor TR1 may be formed from the semiconductor pattern. FIG. 6 shows a portion of the signal transmission area SCL formed from the semiconductor pattern. Although not shown in figures, the signal transmission area SCL may be connected to the drain D of the transistor TR1 in a plane.

In an embodiment, the first, second, third, fourth, and fifth insulating layers 10, 20, 30, 40, and 50, respectively, may be disposed on the buffer layer BFL. Each of the first to fifth insulating layers 10 to 50, respectively, may be an inorganic layer or an organic layer.

In an embodiment, the first insulating layer 10 may be disposed on the buffer layer BFL. A gate G may be disposed on the first insulating layer 10. The second insulating layer 20 may be disposed on the first insulating layer 10 and may cover the gate G. The electrode EE may be disposed on the second insulating layer 20. The third insulating layer 30 may be disposed on the second insulating layer 20 and may cover the electrode EE.

In an embodiment, a first connection electrode CNE1 may be disposed on the third insulating layer 30. The first connection electrode CNE1 may be connected to the signal transmission area SCL via a contact hole CNT-1 defined through the first, second, and third insulating layers 10, 20, and 30, respectively. The fourth insulating layer 40 may be disposed on the third insulating layer 30 and may cover the first connection electrode CNE1. The fourth insulating layer 40 may be an organic layer.

In an embodiment, a second connection electrode CNE2 may be disposed on the fourth insulating layer 40. The second connection electrode CNE2 may be connected to the first connection electrode CNE1 via a contact hole CNT-2 defined through the fourth insulating layer 40. The fifth insulating layer 50 may be disposed on the fourth insulating layer 40 and may cover the second connection electrode CNE2. The fifth insulating layer 50 may be an organic layer.

In an embodiment, the display element layer DP-OLED may be disposed on the circuit element layer DP-CL. The display element layer DP-OLED may include the light emitting element ED, a pixel definition layer PDL, a barrier wall PW, and dummy patterns DMP.

In an embodiment, the light emitting element ED may include the anode AE (or a first electrode), a conductive pattern, a light emitting pattern EP, and the cathode CE (or a second electrode). Each of the first to third light emitting elements described above may have substantially the same configuration as that of the light emitting element ED of FIG. 6. Descriptions on the anode AE, the conductive pattern, the light emitting pattern EP, and the cathode CE may be equally applied to the anode, the conductive pattern, the light emitting pattern, and the cathode of each of the first to third light emitting elements.

In an embodiment, the anode AE may be disposed on the fifth insulating layer 50 of the circuit element layer DP-CL. The anode AE may be a transmissive electrode, a semi-transmissive electrode, or a reflective electrode. The anode AE may have a conductivity. As an example, the anode AE may be formed from a variety of materials, such as metals, transparent conductive oxides (TCOs), or conductive polymer materials, as long as they have conductivity. The anode AE may have a single-layer or multi-layer structure.

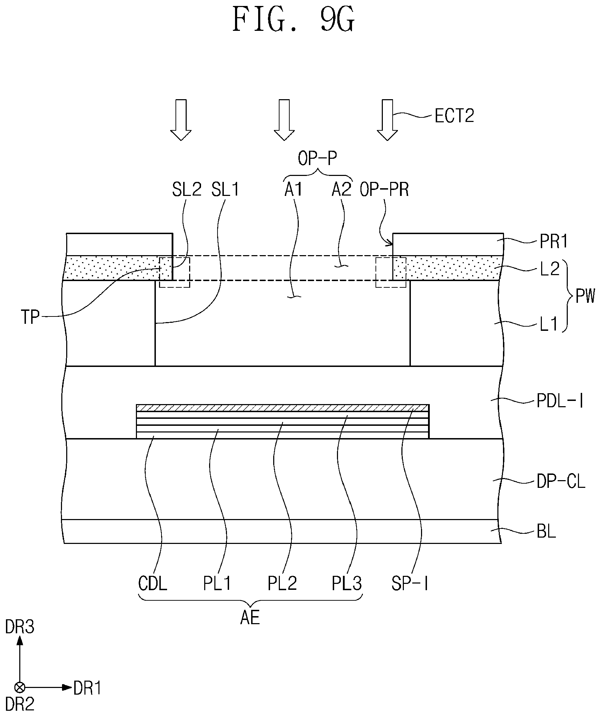

In an embodiment, the anode AE may include a conductive layer CDL and a protective layer PL. The conductive layer CDL may have a conductivity higher than that of the protective layer PL. The conductivity of the anode AE may be determined by the conductivity of the conductive layer CDL. The protective layer PL may cover an upper surface of the conductive layer CDL and may protect the conductive layer CDL. The protective layer PL may have a relatively low reactivity to an etchant compared with the conductive layer CDL. The etchant may be a second etchant ETC2 (refer to FIG. 9G), however, it should not be particularly limited.

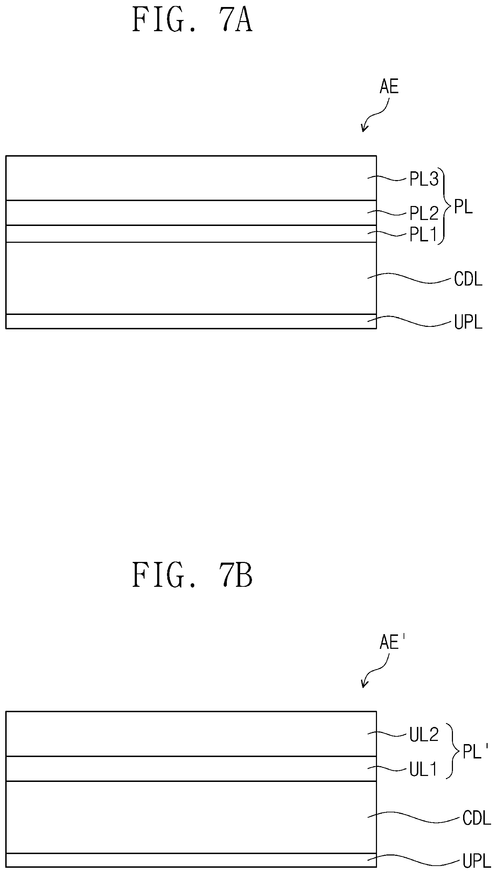

As an example, in an embodiment, the conductive layer CDL may include silver (Ag), and the protective layer PL may include indium tin oxide (ITO), however, the invention should not be limited thereto or thereby. According to an embodiment, the anode AE may have a three-layer structure of indium tin oxide (ITO), silver (Ag), and indium tin oxide (ITO) and should not be particularly limited. The stack structure of the anode AE will be described in detail with reference to FIG. 7A.

In an embodiment, the anode AE may be connected to the second connection electrode CNE2 via a connection contact hole CNT-3 defined through the fifth insulating layer 50. Accordingly, the anode AE may be electrically connected to the signal transmission area SCL via the first and second connection electrodes CNE1 and CNE2 and may be electrically connected to a corresponding circuit element.

According to an embodiment, the display panel DP may further include a sacrificial pattern SP. The sacrificial pattern SP may be disposed on an upper surface of the anode AE. A sacrificial opening OP-S may be defined through the sacrificial pattern SP, and a portion of the upper surface of the anode AE may be exposed through the sacrificial opening OP-S. The sacrificial pattern SP may include an amorphous transparent conductive oxide.

In an embodiment, the pixel definition layer PDL may be disposed on the fifth insulating layer 50 of the circuit element layer DP-CL. The pixel definition layer PDL may be provided with the light emitting opening OP-E defined therethrough. The light emitting opening OP-E may overlap the anode AE, and at least a portion of the anode AE may be exposed through the light emitting opening OP-E of the pixel definition layer PDL.

In addition, in an embodiment, the light emitting opening OP-E may correspond to the sacrificial opening OP-S of the sacrificial pattern SP. According to an embodiment, the upper surface of the anode AE may be spaced apart from the pixel definition layer PDL with the sacrificial pattern SP interposed therebetween when viewed in a cross-section, and thus, the anode AE may be prevented from being damaged in a process of forming the light emitting opening OP-E.

In an embodiment, when viewed in a predetermined direction, a width of the light emitting opening OP-E may be smaller than a width of the sacrificial opening OP-S. In the following descriptions, the predetermined direction may indicate a vertical direction to a thickness direction, i.e., the third direction DR3, of the display panel DP. An inner side surface of the pixel definition layer PDL, which defines the light emitting opening OP-E, may be closer to a center of the anode AE than an inner side surface of the sacrificial pattern SP, which defines the sacrificial opening OP-S, is. However, the invention should not be limited thereto or thereby. According to an embodiment, the inner side surface of the sacrificial pattern SP, which defines the sacrificial opening OP-S, may be substantially aligned with the inner side surface of the pixel definition layer PDL, which defines the corresponding light emitting opening OP-E. In this case, the light emitting area PXA may be an area of the anode AE exposed without being covered by the corresponding sacrificial opening OP-S. Meanwhile, according to an embodiment, the sacrificial pattern SP may be omitted.

In an embodiment, the pixel definition layer PDL may include an inorganic insulating material. As an example, the pixel definition layer PDL may include silicon nitride (SiNₓ). The pixel definition layer PDL may be disposed between the anode AE and the barrier wall PW and may block the anode AE from being electrically connected to the barrier wall PW.

In an embodiment, the barrier wall PW may be disposed on the pixel definition layer PDL. The barrier wall PW may be provided with a barrier wall opening OP-P defined therethrough. The barrier wall opening OP-P may correspond to the light emitting opening OP-E, and at least a portion of the anode AE may be exposed through the barrier wall opening OP-P.

In an embodiment, the barrier wall PW may have an undercut shape in the cross-section. The barrier wall PW may include a plurality of layers sequentially stacked, and at least one of the layers may be recessed relative to adjacent layers. Accordingly, the barrier wall PW may include a tip portion TP (refer to FIG. 9G).

In an embodiment, the barrier wall PW may include a first barrier wall layer L1 and a second barrier wall layer L2. The first barrier wall layer L1 may be disposed on the pixel definition layer PDL, and the second barrier wall layer L2 may be disposed on the first barrier wall layer L1. As shown in FIG. 6, the first barrier wall layer L1 may have a thickness greater than a thickness of the second barrier wall layer L2, however, it should not be limited thereto or thereby. FIG. 6 shows the structure in which the barrier wall PW includes only the first barrier wall layer L1 and the second barrier wall layer L2, however, the invention should not be limited thereto or thereby. According to an embodiment, a third barrier wall layer may be disposed on the second barrier wall layer L2. In addition, the third barrier wall layer may have a thickness greater than the thickness of the second barrier wall layer L2.

In an embodiment, the first barrier wall layer L1 may have conductivity. As an example, the first barrier wall layer L1 may include a conductive material. The conductive material may include metals, metal nitrides, transparent conductive oxides (TCOs), or combinations thereof. As an example, the metals may include gold (Au), silver (Ag), aluminum (Al), magnesium (Mg), lithium (Li), molybdenum (Mo), titanium (Ti), copper (Cu), and/or alloys. The metal nitrides may include titanium nitride (TiN). The transparent conductive oxides may include indium tin oxide (ITO), indium zinc oxide (IZO), zinc oxide, indium oxide, indium gallium oxide, indium gallium zinc oxide (IGZO), and/or aluminum zinc oxide.

In an embodiment, the second barrier wall layer L2 may be disposed on the first barrier wall layer L1. The second barrier wall layer L2 may include a material having an etch selectivity with respect to the first barrier wall layer L1. As an example, the reactivity of the second barrier wall layer L2 to the second etchant ETC2 (refer to FIG. 9G) described later may be lower than that of the first barrier wall layer L1.

In an embodiment, the first barrier wall layer L1 may be recessed relative to the second barrier wall layer L2 with respect to the light emitting area PXA. That is, the first barrier wall layer L1 may be undercut with respect to the second barrier wall layer L2. A portion of the second barrier wall layer L2, which protrudes more than the first barrier wall layer L1 to the light emitting area PXA, may be defined as the tip portion TP (refer to FIG. 9G).

In an embodiment, the second barrier wall layer L2 may include a conductive material. As an example, the conductive material may include metals, metal nitrides, transparent conductive oxides (TCOs), and/or combinations thereof. As an example, the metals may include gold (Au), silver (Ag), aluminum (Al), magnesium (Mg), lithium (Li), molybdenum (Mo), titanium (Ti), copper (Cu), and/or alloys. The metal nitrides may include titanium nitride (TiN). The transparent conductive oxides may include indium tin oxide (ITO), indium zinc oxide (IZO), zinc oxide, indium oxide, indium gallium oxide, indium gallium zinc oxide (IGZO), and/or aluminum zinc oxide.

According to an embodiment, the second barrier wall layer L2 may include an insulating material. As an example, the second barrier wall layer L2 may include an inorganic insulating material, e.g., silicon nitride (SiNx) or silicon oxide (SiOx), however, this is merely an example. According to an embodiment, the second barrier wall layer L2 may be omitted from the barrier wall PW.

In an embodiment, the barrier wall opening OP-P may be provided with a first area A1 and a second area A2, which are defined therein. The first barrier wall layer L1 may include a first inner side surface SL1 that defines the first area A1 of the barrier wall opening OP-P, and the second barrier wall layer L2 may include a second inner side surface SL2 that defines the second area A2 of the barrier wall opening OP-P.

In an embodiment, when viewed in the cross-section, the second area A2 may have a diameter DD2 smaller than a diameter DD1 of the first area A1. The second inner side surface SL2 may be closer to the center of the anode AE than is the first inner side surface SL1. In other words, the first inner side surface SL1 may be recessed in a direction away from the center of anode AE when compared with the second inner side surface SL2. Accordingly, the second barrier wall layer L2 may include a lower surface exposed without being covered by the first barrier wall layer L1.

In an embodiment, the barrier wall PW may have an undercut shape when viewed in the cross-section. As described above, the undercut shape of the barrier wall PW may be defined by a step difference between the first inner side surface SL1 of the first barrier wall layer L1 and the second inner side surface SL2 of the second barrier wall layer L2. Meanwhile, the shape of the barrier wall PW in the cross-section should not be limited to the undercut shape, and the barrier wall PW may have a variety of shapes, such as a reverse taper shape, an overhang shape, etc., as long as the diameter DD2 of the second area A2 is smaller than the diameter DD1 of the first area A1.

In an embodiment, FIG. 6 shows the structure in which each of the first and second inner side surfaces SL1 and SL2, respectively, are perpendicular to an upper surface of the fifth insulating layer 50 as a representative example, however, the invention should not be limited thereto or thereby.

In an embodiment, the light emitting pattern EP may be disposed on the anode AE. The light emitting pattern EP may be patterned by the tip portion TP defined in the barrier wall PW. At least a portion of the light emitting pattern EP may be disposed in the light emitting opening OP-E. The light emitting pattern EP may be entirely disposed in the light emitting opening OP-E, and the light emitting pattern EP may be disposed in the barrier wall opening OP-P as well as the light emitting opening OP-E. According to an embodiment including the sacrificial pattern SP, the light emitting pattern EP may also be disposed in the sacrificial opening OP-S.

In an embodiment, the light emitting pattern EP may include the light emitting layer including a light emitting material. The light emitting pattern EP may further include a hole injection layer and a hole transport layer between the anode AE and the light emitting layer and may further include an electron transport layer and an electron injection layer, which are disposed on the light emitting layer. The light emitting pattern EP may be referred to as an organic layer or an intermediate layer.

In an embodiment, the cathode CE may be disposed on the light emitting pattern EP. The cathode CE may be patterned by the tip portion TP defined in the barrier wall PW. At least a portion of the cathode CE may be disposed in the barrier wall opening OP-P. According to an embodiment, a portion of the cathode CE may also be disposed in the light emitting opening OP-E according to the thickness of the light emitting pattern EP and/or the thickness of the pixel definition layer PDL.

In an embodiment, the cathode CE may have the conductivity. As an example, the cathode CE may be formed from a variety of materials, such as metals, transparent conductive oxides (TCOs), or conductive polymer materials, as long as they have conductivity.

According to an embodiment, the display panel DP may further include a capping pattern CP. The capping pattern CP may be disposed on the cathode CE. The capping pattern CP may be patterned by the tip portion TP defined in the barrier wall PW. At least a portion of the capping pattern CP may be disposed in the barrier wall opening OP-P. FIG. 6 shows the structure in which the capping pattern CP is disposed in the barrier wall opening OP-P and the light emitting opening OP-E as a representative example, however, the invention should not be limited thereto or thereby. According to an embodiment, the capping pattern CP may be disposed only in the barrier wall opening OP-P E according to the thickness of the light emitting pattern EP and/or the thickness of the pixel definition layer PDL.

In an embodiment, the dummy patterns DMP may be disposed on the barrier wall PW. The dummy patterns DMP may include a first dummy pattern D1, a second dummy pattern D2, and a third dummy pattern D3. The first, second, and third dummy patterns D1, D2, and D3, respectively, may be sequentially stacked in the second direction DR2.

In an embodiment, the first dummy pattern D1 may include an organic material. As an example, the first dummy pattern D1 may include substantially the same material as the light emitting pattern EP. The first dummy pattern D1 may be substantially simultaneously formed with light emitting pattern EP through a single process and may be formed separately from the light emitting pattern EP due to the undercut shape of the barrier wall PW.

In an embodiment, the second dummy pattern D2 may include a conductive material. As an example, the second dummy pattern D2 may include the same material as that of the cathode CE. The second dummy pattern D2 may be substantially simultaneously formed with the cathode CE through a single process and may be separated from the cathode CE due to the undercut shape of the barrier wall PW.

In an embodiment, the third dummy pattern D3 may include the same material as that of the capping pattern CP. The third dummy pattern D3 may be substantially simultaneously formed with the capping pattern CP through a single process and may be separated from the capping pattern CP due to the undercut shape of the barrier wall PW.

In an embodiment, a dummy opening OP-D may be defined through the dummy patterns DMP. The dummy opening OP-D may correspond to the light emitting opening OP-E. The dummy opening OP-D may be defined by inner side surfaces of the first, second, and third dummy patterns D1, D2, and D3, respectively. When viewed in the plane, the dummy patterns DMP may have a closed-line shape extending along a periphery of the light emitting area PXA.

In an embodiment, FIG. 6 shows the structure in which the inner side surfaces of the first, second, and third dummy patterns D1, D2, and D3, respectively, are aligned with the second inner side surface SL2 as a representative example, however, the invention should not be limited thereto or thereby. According to an embodiment, the first, second, and third dummy patterns D1, D2, and D3 may cover the second inner side surface SL2.

In an embodiment, the thin film encapsulation layer TFE may be disposed on the display element layer DP-OLED. The thin film encapsulation layer TFE may include a lower encapsulation inorganic pattern LIL, an encapsulation organic layer OL, and an upper encapsulation inorganic layer UIL.

In an embodiment, the lower encapsulation inorganic pattern LIL may cover the light emitting element ED. In detail, the lower encapsulation inorganic pattern LIL may cover the cathode CE and may further cover the capping pattern CP disposed on the cathode CE.

In an embodiment, the portion of the lower encapsulation inorganic pattern LIL may be disposed inside the light emitting opening OP-E and the barrier wall opening OP-P. According to an embodiment, the lower encapsulation inorganic pattern LIL may be in contact with an upper surface of the dummy patterns DMP and the inner side surfaces of the dummy patterns DMP, which define the dummy opening OP-D.

In an embodiment, the encapsulation organic layer OL may cover the lower encapsulation inorganic pattern LIL and may provide a flat upper surface thereon. The upper encapsulation inorganic layer UIL may be disposed on the encapsulation organic layer OL.

In an embodiment, the lower encapsulation inorganic pattern LIL and the upper encapsulation inorganic layer UIL may protect the display element layer DP-OLED from moisture and oxygen, and the encapsulation organic layer OL may protect the display element layer DP-OLED from a foreign substance such as dust particles.

FIGS. 7A and 7B are enlarged cross-sectional views of a portion of a display panel DP according to embodiments of the invention. In detail, in an embodiment, FIG. 7A is an enlarged cross-sectional view of the anode AE of FIG. 6. Fig 7B is enlarged cross-sectional view of an anode AE', of a different embodiment than that of Fig 7A.

In an embodiment and referring to FIG. 7A, the anode AE may include the conductive layer CDL and the protective layer PL.

In an embodiment, the conductive layer CDL may be disposed on the circuit element layer DP-CL (refer to FIG. 6). The protective layer PL may be disposed on the conductive layer CDL. As an example, the protective layer PL may cover at least a portion of the conductive layer CDL. The protective layer PL may prevent the conductive layer CDL from being damaged. As an example, the protective layer PL may prevent the damage of the conductive layer CDL, which is caused by a second etchant ETC2 (refer to FIG. 9G) in a process of forming the barrier wall PW.

In an embodiment, the protective layer PL may have a transmittance equal to or greater than about 90% of a visible wavelength range. According to an embodiment, the protective layer PL may have a transmittance equal to or greater than about 95% withina wavelength range equal to or greater than about 400nm and equal to or smaller than about 800nm.

In an embodiment, the protective layer PL may include a first protective layer PL1, a second protective layer PL2, and a third protective layer PL3. The first protective layer PL1 may be disposed on the conductive layer CDL, the second protective layer PL2 may be disposed on the first protective layer PL1, and the third protective layer PL3 may be disposed on the second protective layer PL2. As an example, the first, second, and third protective layers PL1, PL2, and PL3, respectively, may be sequentially disposed on the conductive layer CDL in a direction away from the conductive layer CDL, and the first, second, and third protective layers PL1, PL2, and PL3, respectively, may be referred to as first, second, and third layers in the order of arrangement on the conductive layer CDL, respectively.

In an embodiment, the first protective layer PL1 may have a polycrystalline structure. Since the first protective layer PL1 has the polycrystalline structure, the first protective layer PL1 is prevented from being etched by the second etchant ETC2 (refer to FIG. 9G) in the process of forming the barrier wall.

In an embodiment, the first protective layer PL1 may include indium tin oxide (ITO). The first protective layer PL1 including indium tin oxide (ITO) may have high transmittance, and thus, the display quality of the display panel may be prevented from being deteriorated.

According to an embodiment, the first protective layer PL1 may have a thickness equal to or greater than about 70 angstroms (Å) and equal to or smaller than about 115 angstroms (Å). When the thickness of the first protective layer PL1 is equal to or smaller than about 115 angstroms (Å), the occurrence of residues in the first protective layer PL1 may be prevented, and the transmittance of the display panel may be prevented from being deteriorated.

In an embodiment, since the second protective layer PL2 has the amorphous structure, the second etchant ETC2 (refer to FIG. 9G) may be prevented from infiltrating into the second protective layer PL2 and reaching the first protective layer PL1 in the process of forming the barrier wall. The second protective layer PL2 having the amorphous structure may slow down a speed at which the second etchant ETC2 (refer to FIG. 9G) infiltrates into a grain boundary and reaches the first protective layer PL1.

In an embodiment, the second protective layer PL2 may include zinc indium tin oxide (ZITO). The second protective layer PL2 including zinc indium tin oxide (ZITO) may have high transmittance and may prevent the display quality of the display panel from being deteriorated.

In an embodiment, the second protective layer PL2 may have a thickness equal to or greater than about 100 angstroms (Å) and equal to or smaller than about 500 angstroms (Å). When the thickness of the second protective layer PL2 is equal to or smaller than about 500 angstroms (Å), the transmittance of the display panel may be prevented from being deteriorated.

Table 1 below shows the transmittance for each wavelength of zinc indium tin oxide (ZITO) and indium tin oxide (ITO), each having the thickness of about 150 angstroms (Å), according to an embodiment.

**Table 1**

| | 450nm | 550nm | 650nm |
|---|---|---|---|
| ZITO 150 Å | 95% | 97% | 98% |
| ITO 150 Å | 94% | 96.6% | 97.9% |

In an embodiment, the second protective layer PL2 including zinc indium tin oxide (ZITO) may have a transmittance that is similar to that of the second protective layer PL2 including indium tin oxide (ITO). Similar to the second protective layer PL2 having indium tin oxide (ITO), the second protective layer PL2 having zinc indium tin oxide (ZITO) has high transmittance, and thus, deterioration in display quality of the display panel may be prevented.

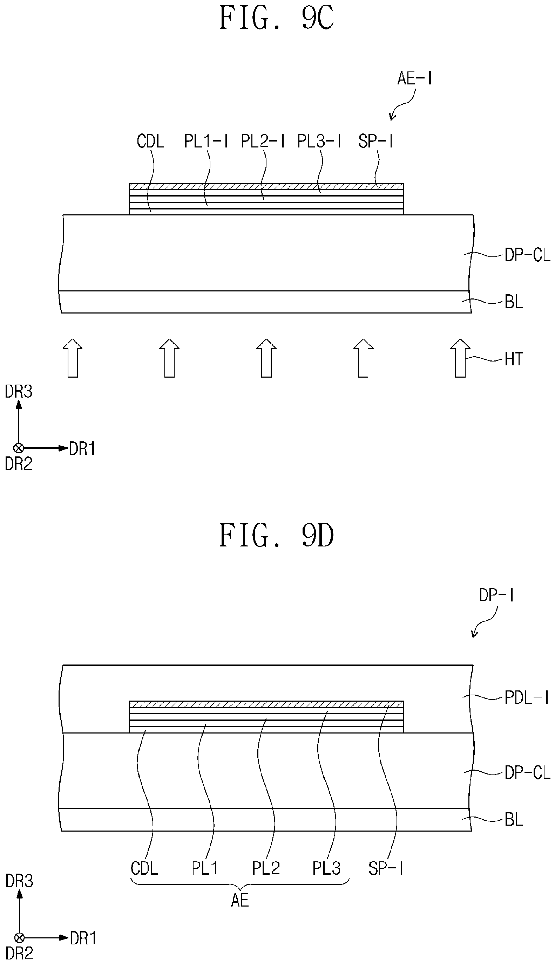

In addition, in an embodiment, the second protective layer PL2 having zinc indium tin oxide (ZITO) may allow a second preliminary protective layer PL2-I (refer to FIG. 9C) and a second protective layer PL2 to have the same amorphous structure before and after a process of heating a preliminary anode AE-I (refer to FIG. 9C) to be described later.

In an embodiment, the second protective layer PL2 may include indium zinc oxide (IZO) with the amorphous structure or indium gallium zinc oxide with the amorphous structure, however, it should not be particularly limited.

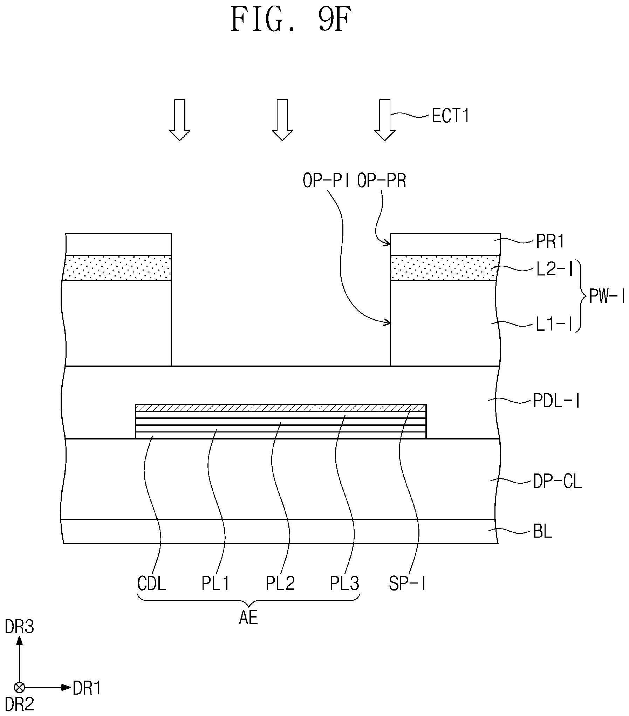

In an embodiment, since the third protective layer PL3 has the polycrystalline structure, the third protective layer PL3 is prevented from being etched by a first etchant ETC1 (refer to FIG. 9F) or the second etchant ETC2 (refer to FIG. 9G) in the process of forming the barrier wall. In addition, the third protective layer PL3 may prevent the second etchant ETC2 (refer to FIG. 9G) from infiltrating into the third protective layer PL3 and reaching the second protective layer PL2 or the first protective layer PL1.

In an embodiment, the third protective layer PL3 may include indium tin oxide (ITO) or zinc indium tin oxide (ZITO). The third protective layer PL3 having indium tin oxide (ITO) may have high transmittance and may prevent the display quality of the display panel from being deteriorated. As an example, the third protective layer PL3 may have the transmittance equal to or greater than about 95.7% or equal to or greater than about 96%.

In an embodiment, the third protective layer PL3 may have a thickness equal to or greater than about 100 angstroms (Å) and equal to or smaller than about 700 angstroms (Å). When the thickness of the third protective layer PL3 is equal to or smaller than about 700 angstroms (Å), the transmittance of the display panel may be prevented from being deteriorated. The thickness of the third protective layer PL3 may be greater than the thickness of the first protective layer PL1, and the thickness of the third protective layer PL3 may be greater than the thickness of the second protective layer PL2.

In an embodiment, the third protective layer PL3 may be in contact with the light emitting pattern EP as the intermediate layer. The third protective layer PL3 may include the hole injection layer. As an example, the third protective layer PL3 may have a work function of about 4.83 eV or more and about 4.85 eV or less, and particularly, about 4.84 eV or more and about 4.85 eV or less.

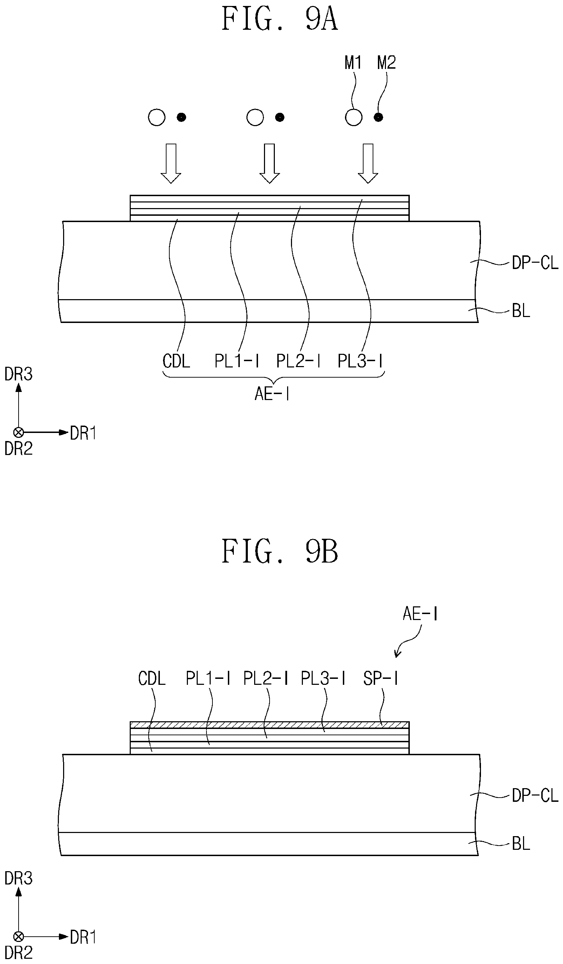

In an embodiment, when a third preliminary protective layer PL3-I (refer to FIG. 9A) is formed, residues on the third protective layer PL3 may be prevented by using argon and hydrogen gases. This will be described in detail later.

In an embodiment, the anode AE may further include a lower protective layer UPL.

In an embodiment, the lower protective layer UPL may be disposed between the circuit element layer DP-CL (refer to FIG. 6) and the conductive layer CDL. The lower protective layer UPL may be disposed between the fifth insulating layer 50 (refer to FIG. 6) and the conductive layer CDL. The lower protective layer UPL may be directly in contact with the circuit element layer DP-CL (refer to FIG. 6) and the conductive layer CDL. The conductive layer CDL may be tightly adhered to the circuit element layer DP-CL (refer to FIG. 6) by the lower protective layer UPL. The lower protective layer UPL may include indium tin oxide (ITO).

In an embodiment and referring to FIG. 7B, an anode AE' may include a conductive layer CDL, a first upper layer UL1, and a second upper layer UL2. The first upper layer UL1 may be disposed on the conductive layer CDL, and the second upper layer UL2 may be disposed on the first upper layer UL1. The first upper layer UL1 of FIG. 7B may correspond to the second protective layer PL2 of FIG. 7A, and the second upper layer UL2 of FIG. 7B may correspond to the third protective layer PL3 of FIG. 7A. The third protective layer PL3 may be omitted, and in this case, the second protective layer PL2 may contact with the light emitting pattern EP.

In an embodiment, when compared with the embodiment of FIG. 7A, the first protective layer PL1 (refer to FIG. 7A) is omitted from the embodiment of FIG. 7B. When the first protective layer PL1 (refer to FIG. 7A) is omitted, the transmittance of the display panel may be more improved, and the size of the display panel may be reduced.

FIG. 8 is a cross-sectional view of the display panel according to an embodiment. In detail, FIG. 8 is a cross-sectional view taken along a line II-II' of FIG. 5.

In an embodiment, FIG. 8 is an enlarged cross-sectional view of one first light emitting area PXA-R, one second light emitting area PXA-G, and one third light emitting area PXA-B, and the above-descriptions on the light emitting area PXA of FIG. 6 may be equally applied to the first, second, and third light emitting areas PXA-R, PXA-G, and PXA-B, respectively.

In an embodiment and referring to FIG. 8, the display panel DP may include the base layer BL, the circuit element layer DP-CL, the display element layer DP-OLED, and the thin film encapsulation layer TFE. The display element layer DP-OLED may include the light emitting elements ED1, ED2, and ED3, sacrificial patterns SP1, SP2, and SP3, the pixel definition layer PDL, the barrier wall PW, and the dummy patterns DMP.

In an embodiment, the light emitting elements ED1, ED2, and ED3 may include a first light emitting element ED1, a second light emitting element ED2, and a third light emitting element ED3. The first light emitting element ED1 may include a first anode AE1, a first light emitting pattern EP1, and a first cathode CE1, the second light emitting element ED2 may include a second anode AE2, a second light emitting pattern EP2, and a second cathode CE2, and the third light emitting element ED3 may include a third anode AE3, a third light emitting pattern EP3, and a third cathode CE3. The first, second, and third anodes AE1, AE2, and AE3, respectively, may be provided in plural patterns.

In an embodiment, each of the first, second, and third light emitting patterns EP1, EP2, and EP3, respectively, may include at least the light emitting layer. The light emitting layer may include a light emitting material. As an example, the light emitting layer may emit red, green, and blue lights. The first light emitting pattern EP1 may provide the red light, the second light emitting pattern EP2 may provide the green light, and the third light emitting pattern EP3 may provide the blue light.

Meanwhile, in an embodiment, each of the light emitting patterns EP1, EP2, and EP3 may further include a common layer in addition to the light emitting layer. The common layer may reduce a difference in electric potential between each of the anodes AE1, AE2, and AE3 and the light emitting layer or between each of the cathodes CE1, CE2, and CE3 and the light emitting layer, and thus, a light emission efficiency may be improved. The common layer may include a hole control layer and/or an electron control layer. As an example, the hole control layer may include a hole transport layer and a hole injection layer, which are disposed between the anode and the light emitting layer. As an example, the electron control layer may include an electron transport layer and an electron injection layer, which are disposed between the cathode and the light emitting layer, however, the invention should not be limited thereto or thereby. According to an embodiment, the common layer may include various layers, such as an electron blocking layer, a hole blocking layer, etc., and, the invention should not be limited thereto or thereby.

In an embodiment, the anodes AE1, AE2, and AE3 may respectively include conductive layers CDLa, CDLb, and CDLc and may respectively include protective layers PLa, PLb, and PLc. The first anode AE1 may include a first conductive layer CDLa and a first protective layer PLa. The second anode AE2 may include a second conductive layer CDLb and a second protective layer PLb. The third anode AE3 may include a third conductive layer CDLc and a third protective layer PLc.

In an embodiment, first, second, and third light emitting openings OP1-E, OP2-E, and OP3-E, respectively may be defined through the pixel definition layer PDL. The first light emitting opening OP1-E may expose at least a portion of the first anode AE1. The first light emitting area PXA-R may be defined as an area of an upper surface of the first anode AE1, which is exposed through the first light emitting opening OP1-E. The second light emitting opening OP2-E may expose at least a portion of the second anode AE2. The second light emitting area PXA-G may be defined as an area of an upper surface of the second anode AE2, which is exposed through the second light emitting opening OP2-E. The third light emitting opening OP3-E may expose at least a portion of the third anode AE3. The third light emitting area PXA-B may be defined as an area of an upper surface of the third anode AE3, which is exposed through the third light emitting opening OP3-E.

In an embodiment, the sacrificial patterns SP1, SP2, and SP3 may include a first sacrificial pattern SP1, a second sacrificial pattern SP2, and a third sacrificial pattern SP3. The first, second, and third sacrificial patterns SP1, SP2, and SP3, respectively, may be disposed on the upper surfaces of the first, second, and third anodes AE1, AE2, and AE3, respectively. First, second, and third sacrificial openings OP1-S, OP2-S, and OP3-S, respectively, may be defined through the first, second, and third sacrificial patterns SP1, SP2, and SP3, respectively, to respectively correspond to the first, second, and third light emitting openings OP1-E, OP2-E, and OP3-E, respectively.

In an embodiment, the first, second, and third barrier wall openings OP1-P, OP2-P, and OP3-P, respectively, may be defined through the barrier wall PW to respectively correspond to the first, second, and third light emitting openings OP1-E, OP2-E, and OP3-E, respectively. Each of the first, second, and third barrier wall openings OP1-P, OP2-P, and OP3-P, respectively, may include the first area A1 (refer to FIG. 6) and the second area A2 (refer to FIG. 6). The first barrier layer L1 may include the first inner side surfaces SL1 (refer to FIG. 6) that define the first areas A1 of the first, second, and third barrier wall openings OP1-P, OP2-P, and OP3-P, respectively, and the second barrier layer L2 may include the second inner side surfaces SL2 (refer to FIG. 6) that define the second areas A2 of the first, second, and third barrier wall openings OP1-P, OP2-P, and OP3-P, respectively.

In an embodiment, the first light emitting pattern EP1 and the first cathode CE1 may be disposed in the first barrier wall opening OP1-P, the second light emitting pattern EP2 and the second cathode CE2 may be disposed in the second barrier wall opening OP2-P, and the third light emitting pattern EP3 and the third cathode CE3 may be disposed in the third barrier wall opening OP3-P. The first, second, and third cathodes CE1, CE2, and CE3, respectively, may be in contact with the first inner side surfaces SL1 of the first barrier layer L1, respectively.

In an embodiment, the first, second, and third cathodes CE1, CE2, and CE3, respectively, may be physically separated from each other by the second barrier layer L2 forming the tip portion, and may be respectively formed in the light emitting openings OP1-E, OP2-E, and OP3-E, and may be in contact with the first barrier layer L1. Accordingly, the first, second, and third cathodes CE1, CE2, and CE3, respectively, may be electrically connected to each other and may receive a common voltage. As the first barrier wall layer L1 has a relatively high electrical conductivity compared with the second barrier wall layer L2, a contact resistance between the first barrier wall layer L1 and the first, second, and third cathodes CE1, CE2, and CE3, respectively, may be reduced. Thus, a common cathode voltage may be provided evenly to the light emitting areas PXA-R, PXA-G, and PXA-B.

In an embodiment where the light emitting patterns EP1, EP2, and EP3, e.g., the light emitting layer, are formed using a mask such as a metal mask like a fine metal mask (FMM), a support spacer protruding from a conductive barrier wall is required to support the mask. Since the mask is spaced apart from a base surface on which a patterning process is performed by a height of the barrier wall and the support spacer, there may be limitations to implementing a high resolution of the display device. In addition, as the mask is in contact with the support spacer, foreign substances may remain on the support spacer after the patterning process of the first light emitting patterns EP1, or the display panel may be damaged due to the mask that gets scratches. Accordingly, a process reliability of the display panel may be lowered.

According to an embodiment, the first light emitting patterns EP1 may be deposited after being patterned in the unit of pixel by the tip portion TP defined in the barrier wall PW. That is, the first light emitting patterns EP1 may be commonly formed using an open mask but may be easily divided into plural portions in the unit of pixel by the barrier wall PW. Accordingly, the patterning process for each pixel may be easily performed without masks.

In particular, in an embodiment, since the first light emitting patterns EP1 are patterned without masks that are in contact with components in the display area DA (refer to FIG. 1B), a defective rate of the display panel DP may be reduced, and a process reliability of the display panel DP may be improved. As the first light emitting patterns EP1 are patterned without the support spacer protruding from the barrier wall PW, the size of the light emitting areas PXA-R, PXA-G, and PXA-B may be reduced, and the high resolution of the display panel DP may be implemented.

In addition, according to an embodiment, the common layer and the cathodes CE1, CE2, and CE3 may be formed as independent patterns after being separated for each of the light emitting areas PXA-R, PXA-G, and PXA-B using the barrier wall PW. Accordingly, a leakage current or a driving error between the light emitting areas PXA-R, PXA-G, and PXA-B adjacent to each other may be prevented, and the light emitting elements ED1, ED2, and ED3 may be driven independently from each other.

In addition, in an embodiment, when manufacturing a large-sized display panel DP, a process cost may be reduced by omitting a production of a large-sized mask, and the display panel DP may be provided with improved process reliability because the display panel DP is not affected by defects that may occur in the large-sized mask.

In an embodiment, capping patterns CP1, CP2, and CP3 may include a first capping pattern CP1, a second capping pattern CP2, and a third capping pattern CP3. The first, second, and third capping patterns CP1, CP2, and CP3, respectively, may be disposed on the first, second, and third cathodes CE1, CE2, and CE3, respectively, and may be disposed in the first, second, and third barrier wall openings OP1-P, OP2-P, and OP3-P, respectively.

In an embodiment, the dummy patterns DMP may include a plurality of first dummy patterns D1, a plurality of second dummy patterns D2, and a plurality of third dummy patterns D3.

The first dummy patterns D1 may include first-first, first-second, and first-third dummy patterns D11, D12, and D13, respectively, that respectively surround the first, second, and third light emitting areas PXA-R, PXA-G, and PXA-B, respectively, when viewed in the plane. The first-first, first-second, and first-third dummy patterns D11, D12, and D13, respectively, may include the same material as the first, second, and third light emitting patterns EP1, EP2, and EP3, respectively, and may be formed through the same process as the first, second, and third light emitting patterns EP1, EP2, and EP3, respectively.

In an embodiment, the second dummy patterns D2 may include second-first, second-second, and second-third dummy patterns D21, D22, and D23, respectively, that respectively surround the first, second, and third light emitting areas PXA-R, PXA-G, and PXA-B, respectively, when viewed in the plane. The second-first, second-second, and second-third dummy patterns D21, D22, and D23, respectively, may include the same material as the first, second, and third cathodes CE1, CE2, and CE3, respectively, and may be formed through the same process as the first, second, and third cathodes CE1, CE2, and CE3, respectively.

In an embodiment, the third dummy patterns D3 may include third-first, third-second, and third-third dummy patterns D31, D32, and D33, respectively, that respectively surround the first, second, and third light emitting areas PXA-R, PXA-G, and PXA-B, respectively, when viewed in the plane. The third-first, third-second, and third-third dummy patterns D31, D32, and D33, respectively, may include the same material as the first, second, and third capping patterns CP1, CP2, and CP3, respectively, and may be formed through the same process as the first, second, and third capping patterns CP1, CP2, and CP3, respectively.

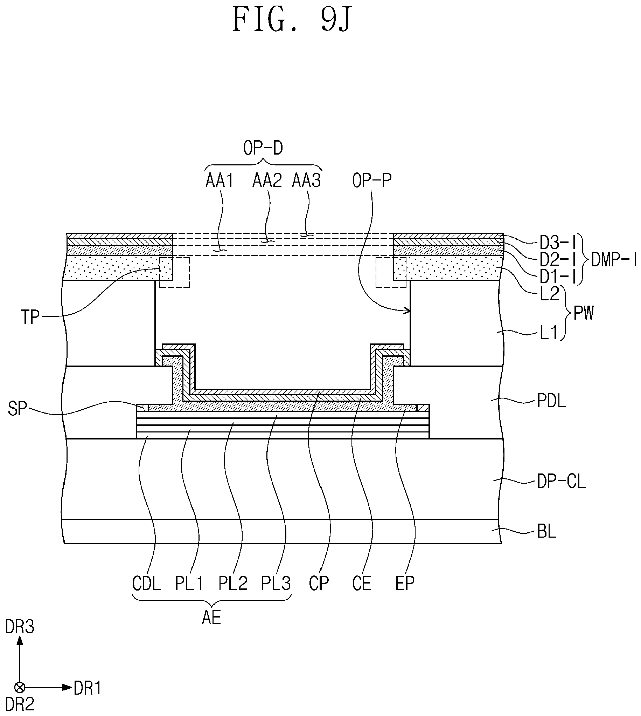

In an embodiment, first, second, and third dummy openings OP1-D, OP2-D, and OP3-D, respectively, that are respectively corresponding to the first, second, and third light emitting openings OP1-E, OP2-E, and OP3-E, respectively, may be defined through the dummy patterns DMP. Each of the first, second, and third dummy openings OP1-D, OP2-D, and OP3-D, respectively, may include first, second, and third areas AA1, AA2, and AA3 (refer to FIG. 9J), respectively, sequentially arranged in the third direction DR3. The first dummy opening OP1-D may be defined by inner side surfaces of the first-first, second-first, and third-first dummy patterns D11, D21, and D31, respectively, the second dummy opening OP2-D may be defined by inner side surfaces of the first-second, second-second, and third-second dummy patterns D12, D22, and D32, respectively, and the third dummy opening OP3-D may be defined by inner side surfaces of the first-third, second-third, and third-third dummy patterns D13, D23, and D33, respectively.

In an embodiment, the thin film encapsulation layer TFE may include lower encapsulation inorganic patterns LIL1, LIL2, and LIL3, the encapsulation organic layer OL, and the upper encapsulation inorganic layer UIL. In an embodiment, the lower encapsulation inorganic patterns LIL1, LIL2, and LIL3 may include a first lower encapsulation inorganic pattern LIL1, a second lower encapsulation inorganic pattern LIL2, and a third lower encapsulation inorganic pattern LIL3. The first, second, and third lower encapsulation inorganic patterns LIL1, LIL2, and LIL3, respectively, may correspond to the first, second, and third light emitting openings OP1-E, OP2-E, and OP3-E, respectively.

In an embodiment, the first lower encapsulation inorganic pattern LIL1 may cover the first light emitting element ED1 and the first-first, second-first, and third-first dummy patterns D11, D21, and D31, respectively, and a portion of the first lower encapsulation inorganic pattern LIL1 may be disposed in the first barrier wall opening OP1-P. The second lower encapsulation inorganic pattern LIL2 may cover the second light emitting element ED2 and the first-second, second-second, and third-second dummy patterns D12, D22, and D32, respectively, and a portion of the second lower encapsulation inorganic pattern LIL2 may be disposed in the second barrier wall opening OP2-P. The third lower encapsulation inorganic pattern LIL3 may cover the third light emitting element ED3 and the first-third, second-third, and third-third dummy patterns D13, D23, and D33, respectively, and a portion of the third lower encapsulation inorganic pattern LIL3 may be disposed in the third barrier wall opening OP3-P. The first, second, and third lower encapsulation inorganic patterns LIL1, LIL2, and LIL3, respectively, may be arranged to be spaced apart from each other in a pattern shape.

FIGS. 9A to 9M are cross-sectional views illustrating a method of manufacturing the display panel according to an embodiment. In FIGS. 9A to 9M, the same reference numerals denote the same elements in FIGS. 1A to 8, and thus, detailed descriptions of the same elements will be omitted.

In an embodiment, the manufacturing method of the display panel may include forming a preliminary anode pattern including the conductive layer and the protective layer including first, second, and third layers sequentially stacked on the conductive layer and having the amorphous structure, heat treating the preliminary anode pattern to form an anode pattern, forming an insulating layer and forming the light emitting openings through which at least a portion of the anode pattern is exposed to form the pixel definition layer, forming a conductive layer on the pixel definition layer and forming the barrier wall opening overlapping the light emitting opening through the conductive layer to form the barrier wall having the undercut shape.

In addition, in an embodiment, the manufacturing method of the display panel may include forming the intermediate layer including the light emitting material in the barrier wall opening and forming the cathode in the barrier wall opening to be in contact with the barrier wall.

Hereinafter, in an embodiment, a method of forming one light emitting element ED, the lower encapsulation inorganic pattern LIL, the encapsulation organic layer OL, and the upper encapsulation inorganic layer UIL, which cover the light emitting element ED, will be described with reference to FIGS. 9A to 9M.

In an embodiment, the manufacturing method of the display panel may include preparing the preliminary anode pattern. The preliminary anode pattern may be disposed on the circuit element layer DP-CL. The circuit element layer DP-CL may be disposed on the base layer BL.

In an embodiment, the circuit element layer DP-CL may be formed by a conventional circuit element manufacturing method. According to the conventional circuit element manufacturing method, an insulating layer, a semiconductor layer, and a conductive layer are formed by a coating or depositing process, the insulating layer, the semiconductor layer, and the conductive layer are patterned by a photolithography process and an etching process, and thus, the semiconductor pattern, the conductive pattern, and the signal line are formed.

In an embodiment, the preliminary anode pattern may include the conductive layer CDL, a first preliminary protective layer PL1-I, a second preliminary protective layer PL2-I, and a third preliminary protective layer PL3-I. The first preliminary protective layer PL1-I may be disposed on the conductive layer CDL, the second preliminary protective layer PL2-I may be disposed on the first preliminary protective layer PL1-I, and the third preliminary protective layer PL3-I may be disposed on the second preliminary protective layer PL2-I. As an example, the first, second, and third preliminary protective layers PL1-I, PL2-I, and PL3-I, respectively, may be directly in contact with each other.

The anode pattern according to an embodiment may include one or more anodes among the anodes AE1, AE2, and AE3 (refer to FIG. 8). The preliminary anode pattern may include one preliminary anode AE-I or at least one of a plurality of preliminary anodes AE-I. Hereinafter, for the convenience of explanation, one preliminary anode AE-I or one anode AE corresponding to one light emitting element ED will be described as a representative example.

In an embodiment, each of the first preliminary protective layer PL1-I, the second preliminary protective layer PL2-I, and the third preliminary protective layer PL3-I may have an amorphous structure. The first preliminary protective layer PL1-I may include indium tin oxide (ITO), the second preliminary protective layer PL2-I may include zinc indium tin oxide (ZITO), and the third preliminary protective layer PL3-I may include indium tin oxide (ITO).

In an embodiment, the first preliminary protective layer PL1-I may have a thickness equal to or greater than about 70 angstroms (Å) and equal to or smaller than about 115 angstroms (Å), the second preliminary protective layer PL2-I may have a thickness equal to or greater than about 100 angstroms (Å) and equal to or smaller than about 500 angstroms (Å), and the third preliminary protective layer PL3-I may have a thickness equal to or greater than about 100 angstroms (Å) and equal to or smaller than about 700 angstroms (Å).

In an embodiment, when the thickness of the first preliminary protective layer PL1-I is equal to or smaller than about 115 angstroms (Å), the occurrence of residues in the first preliminary protective layer PL1-I may be prevented in a process of forming the first preliminary protective layer PL1-I.

In an embodiment and referring to FIG. 9A, the third preliminary protective layer PL3-I may be formed using a gas containing a first material M1 and a second material M2. As an example, the first material M1 may be argon (Ar), and the second material M2 may be hydrogen (H₂).

According to an embodiment, a ratio of hydrogen to argon may be greater than about 0% and equal to or smaller than about 3% in the gas containing argon and hydrogen. According to an embodiment, a ratio of hydrogen to argon may be equal to or greater than about 1.2% and equal to or smaller than about 3% in the gas containing argon and hydrogen.

In an embodiment, when the third preliminary protective layer PL3-I is formed using the gas containing argon and hydrogen, residues may be prevented from occurring in the third preliminary protective layer PL3-I. In detail, when the third preliminary protective layer PL3-I is formed using the gas containing argon and hydrogen, the third preliminary protective layer may be prevented from being partially poly-crystallized due to a heat generated from a substrate, and thus, the occurrence of the residues may be prevented.

In an embodiment and referring to FIG. 9B, the manufacturing method of the display panel may include forming a preliminary sacrificial pattern SP-I on the preliminary anode AE-I.

In an embodiment, the preliminary sacrificial pattern SP-I may cover the preliminary anode AE-I. The preliminary sacrificial pattern SP-I may cover the third preliminary protective layer PL3-I.

In an embodiment and referring to FIG. 9B, the preliminary sacrificial pattern SP-I and the preliminary anode AE-I are formed through different patterning processes, however, the invention should not be limited thereto or thereby. The preliminary sacrificial pattern SP-I and the preliminary anode AE-I may be formed through the same patterning process.

In an embodiment and referring to FIG. 9C, the manufacturing method of the display panel may include heat treating HT the preliminary anode AE-I.

In an embodiment, the anode AE (refer to FIG. 9D) may be formed through the heat treating of the preliminary anode AE-I. In the heat treating of the preliminary anode AE-I, the amorphous structure of the first preliminary protective layer PL1-I may be changed to form the first protective layer PL1 (refer to FIG. 9D), the amorphous structure of the third preliminary protective layer PL3-I may be changed to form the third protective layer PL3 (refer to FIG. 9D), and the second protective layer PL2 (refer to FIG. 9D) may be formed without the change in amorphous structure of the second preliminary protective layer PL2-I.

In other words, in an embodiment, after the heat treating process, different from the first preliminary protective layer PL1-I having the amorphous structure, the first protective layer PL1 (refer to FIG. 9D) may have the polycrystalline structure. The second preliminary protective layer PL2-I and the second protective layer PL2 (refer to FIG. 9D) may have the amorphous structure. Different from the third preliminary protective layer PL3-I having the amorphous structure, the third protective layer PL3 (refer to FIG. 9D) may have the polycrystalline structure.

In an embodiment, the third protective layer PL3 (refer to FIG. 9D) may have the polycrystalline structure, and thus, the third protective layer PL3 (refer to FIG. 9D) may be prevented from being etched due to the first etchant ETC1 (refer to FIG. 9F) and/or the second etchant ETC2 (refer to FIG. 9G) in the process of forming the barrier wall described later. In addition, the second etchant ETC2 (refer to FIG. 9G) may be prevented from infiltrating into the third protective layer PL3 (refer to FIG. 9D) and reaching the second protective layer PL2 (refer to FIG. 9D) or the first protective layer PL1 (refer to FIG. 9D).

In an embodiment, the second protective layer PL2 (refer to FIG. 9D) may have the amorphous structure, and thus, the second etchant ETC2 (refer to FIG. 9G) may be prevented from infiltrating into the second protective layer PL2 (refer to FIG. 9D) and reaching the first protective layer PL1 (refer to FIG. 9D) in the process of forming the barrier wall described later. The second protective layer PL2 (refer to FIG. 9D) having the amorphous structure may slow down the speed at which the second etchant ETC2 (refer to FIG. 9G) infiltrates into the grain boundary and reaches the first protective layer PL 1 (refer to FIG. 9D).

In an embodiment, the process of heat-treating HT the preliminary anode AE-I may be performed within a temperature range equal to or greater than about 200 degrees Celsius and equal to or smaller than about 260 degrees Celsius. As the preliminary anode AE-I is heat-treated HT at a temperature equal to or smaller than about 260 degrees Celsius, the first preliminary protective layer PL1-I, the second preliminary protective layer PL2-I, or the third preliminary protective layer PL3-I may be prevented from being excessively heat treated. As the first to third preliminary protective layers PL1-I to PL3-I, respectively, are prevented from being excessively heat treated, the deterioration of the display quality of the display panel may be prevented.

In an embodiment, the heat treatment time for the preliminary anode AE-I may be within about one hour. According to an embodiment, the heat treatment time for the preliminary anode AE-I may be within a range of about 30 minutes or more and about one hour or less. As the preliminary anode AE-I is heat-treated for one hour or less, the first preliminary protective layer PL1-I, the second preliminary protective layer PL2-I, and/or the third preliminary protective layer PL3-I may be prevented from being excessively heat treated.

Referring to FIG. 9D, the manufacturing method of the display panel may include preparing a preliminary display panel, according to an embodiment.

In an embodiment, after the heat treating of the preliminary anode AE-I to form the anode AE, a preliminary pixel definition layer PDL-I may be formed on the anode AE to form the preliminary display panel DP-I.

The preliminary display panel DP-I prepared in an embodiment may include the base layer BL, the circuit element layer DP-CL, the anode AE, the preliminary sacrificial pattern SP-I, and the preliminary pixel definition layer PDL-I. The preliminary pixel definition layer PDL-I may cover the anode AE and the preliminary sacrificial pattern SP-I.

In an embodiment, the third protective layer PL3 may have the polycrystalline structure, and thus, the third protective layer PL3 may be prevented from being etched by the first etchant ETC1 (refer to FIG. 9F) and/or the second etchant ETC2 (refer to FIG. 9G) in the process of forming the barrier wall described later. In addition, the third protective layer PL3 may prevent the first etchant ETC 1 (refer to FIG. 9F) and/or the second etchant ETC2 (refer to FIG. 9G) from infiltrating into the third protective layer PL3 and reaching the second protective layer PL2 or the first protective layer PL1.

In an embodiment, the second protective layer PL2 may have the amorphous structure and may prevent the first etchant ETC1 (refer to FIG. 9F) and/or the second etchant ETC2 (refer to FIG. 9G) from infiltrating into the second protective layer PL2 and reaching the first protective layer PL1 in the process of forming the barrier wall described later. The second protective layer PL2 having the amorphous structure may slow down the speed at which the first etchant ETC1 (refer to FIG. 9F) and/or the second etchant ETC2 (refer to FIG. 9G) infiltrates into the grain boundary and reaches the first protective layer PL1.

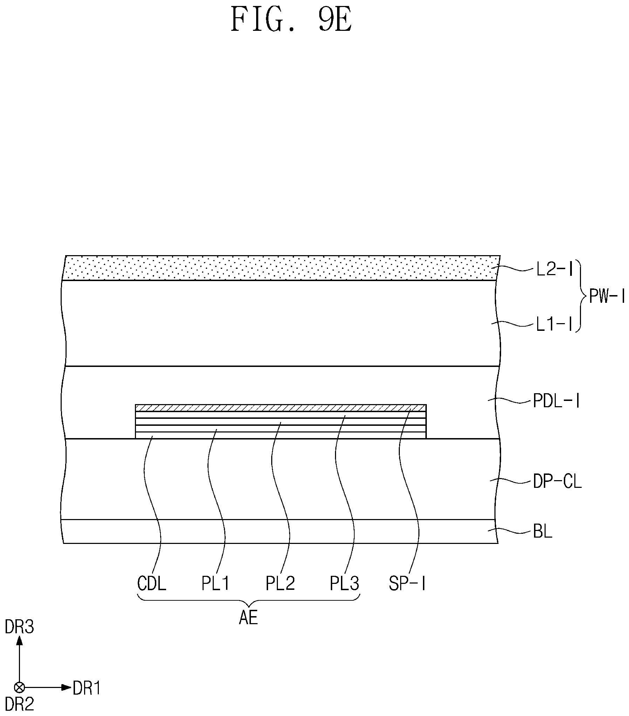

In an embodiment and referring to FIG. 9E, the manufacturing method of the display panel may include forming a first preliminary barrier wall layer L1-I on the preliminary pixel definition layer PDL-I and forming a second preliminary barrier wall layer L2-I on the first preliminary barrier wall layer L1-I to form a preliminary barrier wall PW-I.

In an embodiment, the forming of the first preliminary barrier wall layer L1-I may be performed through a deposition process using a conductive material. In an embodiment, the conductive material used to form the first preliminary barrier wall layer L1 - I may include indium zinc oxide.

In an embodiment, the forming of the second preliminary barrier wall layer L2-I may be performed through a deposition process using a conductive material. In an embodiment, the conductive material used to form the second preliminary barrier wall layer L2-I may include oxide of molybdenum-tantalum alloy. The preliminary barrier wall PW-I may include the first preliminary barrier wall layer L1-I and the second preliminary barrier wall layer L2-I.

In an embodiment and referring to FIG. 9F, the manufacturing method of the display panel may include forming a first photoresist layer PR1 on the preliminary barrier wall PW-I. The first photoresist layer PR1 may be formed by forming a preliminary photoresist layer on the preliminary barrier wall PW-I and patterning the preliminary photoresist layer using a photomask. A photo opening OP-PR that overlaps the anode AE may be formed through the first photoresist layer PR1 through the patterning process.

In addition, in an embodiment, the manufacturing method of the display panel may include first etching the first preliminary barrier wall layer L1-I and the second preliminary barrier wall layer L2-I to form the barrier wall PW from the preliminary barrier wall PW-I.

In an embodiment, the first preliminary barrier wall layer L1-I and the second preliminary barrier wall layer L2-I may be etched using the first photoresist layer PR1 as the mask in the first etching process. The first etching may be a dry etching and may include forming a preliminary barrier wall opening OP-PI through the preliminary barrier wall PW-I using the first etchant ETC1.

As an example, in an embodiment, the first dry etching may be performed in an etching environment in which the first preliminary barrier wall layer L1-I and the second preliminary barrier wall layer L2-I have substantially the same etch selectivity. Accordingly, an inner side surface of the first preliminary barrier wall layer L1-I and an inner side surface of the second preliminary barrier wall layer L2-I, which define the preliminary barrier wall opening OP-PI, may be substantially aligned with each other.

In an embodiment and referring to FIG. 9G, the manufacturing method of the display panel may include second etching the preliminary barrier wall PW-I (see FIG. 9F). The second etching of the preliminary barrier wall PW-I may be a process of etching the first preliminary barrier wall layer L1-I (see FIG. 9F) for the second time.

In an embodiment and referring to FIGS. 9F and 9G, the first preliminary barrier wall layer L1-I may be etched using the first photoresist layer PR1 as a mask in the second etching process. The second etching may be a wet etching and may include forming the barrier wall opening OP-P from the preliminary barrier wall opening OP-PI using the second etchant ETC2. The first etchant ETC1 used in the first etching may be different from the second etchant ETC2 used in the second etching.

In an embodiment, the barrier wall opening OP-P may be provided with the first area A1 and the second area A2, which are sequentially defined in the thickness direction, i.e., the third direction DR3. The first barrier wall layer L1 may include the first inner side surface SL1 that defines the first area A1 of the barrier wall opening OP-P, and the second barrier wall layer L2 may include the second inner side surface SL2 that defines the second area A2.

In an embodiment, the second wet etching process may be performed in an environment in which the etch selectivity between the first preliminary barrier wall layer L1-I and the second preliminary barrier wall layer L2-I is high. Accordingly, the inner side surface of the barrier wall PW, which defines the barrier wall opening OP-P, may have the undercut shape when viewed in the cross-section. In detail, as an etch rate of the first barrier wall layer L1 to the etchant is greater than an etch rate of the second barrier wall layer L2 to the etchant, the first barrier wall layer L1 may be mainly etched. Accordingly, the first inner side surface SL1 of the first barrier wall layer L1 may be more recessed inward than the second inner side surface SL2 of the second barrier wall layer L2. The tip portion TP may be formed in the barrier wall PW by the portion of the second barrier wall layer L2, which protrudes more than the first barrier wall layer L1.

In an embodiment, FIG. 9G shows the process of forming the tip portion TP at the second barrier wall layer L2 of the barrier wall PW by etching the first barrier wall layer L1 as a representative example, however, the invention should not be limited thereto or thereby. As an example, a portion of the first barrier wall layer L1 and a portion of the second barrier wall layer L2 may be wet-etched, and a remaining portion of the second barrier wall layer L2 may be formed as the tip portion.

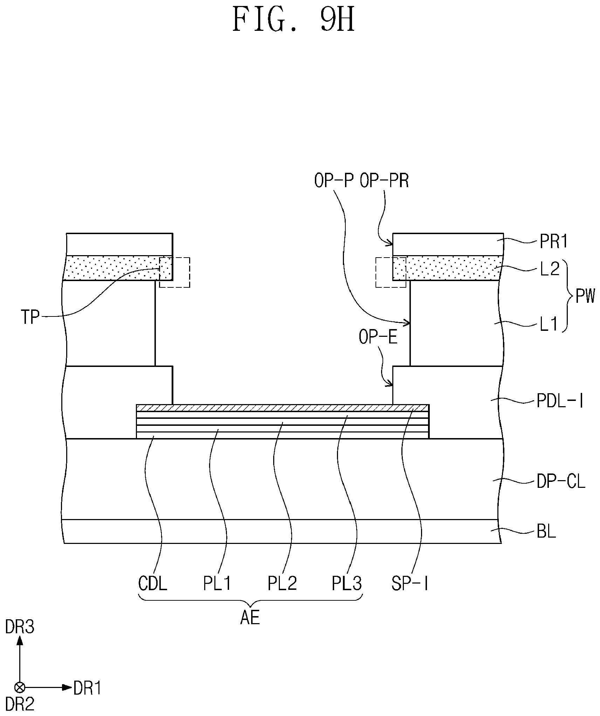

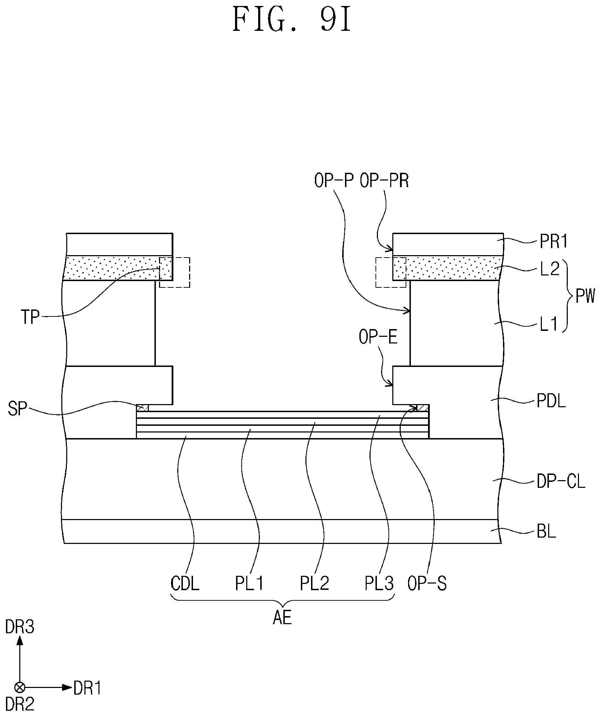

In an embodiment and referring to FIG. 9H, the manufacturing method of the display panel may include etching the preliminary pixel definition layer PDL-I to form the pixel definition layer PDL (refer to FIG. 9I). The etching of the preliminary pixel definition layer PDL-I may be performed by a dry etching method and performed using the first photoresist layer PR1 and the barrier wall PW, e.g., the second barrier wall layer L2, as a mask. The light emitting opening OP-E may be formed through the pixel definition layer PDL to correspond to the barrier wall opening OP-P.

In an embodiment and referring to FIG. 9I, the manufacturing method of the display panel may include etching the preliminary sacrificial pattern SP-I (refer to FIG. 9H). The etching of the preliminary sacrificial pattern SP-I (refer to FIG. 9H) may be performed by a wet etching method and performed using the first photoresist layer PR1 and the barrier wall PW, e.g., the second barrier wall layer L2, as a mask.

In an embodiment and referring to FIGS. 9H and 9I, the sacrificial opening OP-S may be formed through the sacrificial pattern SP formed by etching the preliminary sacrificial pattern SP-I to correspond to the light emitting opening OP-E. At least a portion of the anode AE may be exposed through the sacrificial opening OP-S and the light emitting opening OP-E without being covered by the sacrificial pattern SP and the pixel definition layer PDL. The sacrificial pattern SP may include an azo compound. The sacrificial pattern SP may include zinc oxide (ZnOx) doped with aluminum (Al). In this case, a content of aluminum (Al) may be about 2% or more and about 5 % or less. According to an embodiment, the sacrificial pattern SP may include gallium zinc oxide (GZO).

In an embodiment, the etching of the sacrificial pattern SP may be performed in an environment with high etch selectivity between the sacrificial pattern SP and the anode AE, and thus, the anode AE may be prevented from being etched with the sacrificial pattern SP. That is, as the sacrificial pattern SP having an etch rate higher than that of the anode AE is disposed between the pixel definition layer PDL and the anode AE, the anode AE may be prevented from being etched with the sacrificial pattern SP and from being damaged.

In addition, in an embodiment, the etching of the sacrificial pattern SP may be performed in an environment with high etch selectivity between the sacrificial pattern SP and the first and second barrier wall layers L1 and L2 of the barrier wall PW, and thus, the first and second barrier wall layers L1 and L2 may be prevented from being etched with the sacrificial pattern SP. As an example, the sacrificial pattern SP including the azo compound may have an etch rate of about 370 angstroms/sec, and the first barrier wall layer L1 may have an etch rate of about 19 angstroms/sec. The etch rate of the sacrificial pattern SP may be about 18 to about 30 times faster than the etch rate of the first barrier wall layer L1. Accordingly, an etching loss of the barrier wall PW may be reduced.

In an embodiment and referring to FIG. 9I, the light emitting opening OP-E may have a diameter smaller than a diameter of the sacrificial opening OP-S. A distance in the first direction DR1 between inner side surfaces of the pixel definition layer PDL, which define the light emitting opening OP-E, may be smaller than a distance in the first direction DR1 between inner side surfaces of the sacrificial pattern SP, which define the sacrificial opening OP-S (or a distance in the first direction DR1 between inner side surfaces of the pixel definition layer PDL, which define the sacrificial opening OP-E).

In an embodiment and referring to FIG. 9J, the manufacturing method of the display panel may include forming the light emitting pattern EP, forming the cathode CE, and forming the capping pattern CP after removing the first photoresist layer PR1 (refer to FIG. 9I).

In an embodiment, each of the forming of the light emitting pattern EP, the forming of the cathode CE, and the forming of the capping pattern CP may be carried out in a deposition process. According to an embodiment, the forming of the light emitting pattern EP may be carried out in a thermal evaporation process, the forming of the cathode CE may be carried out in a sputtering process, and the forming of the capping pattern CP may be carried out in a thermal evaporation process, however, they should not be limited thereto or thereby.

In an embodiment, in the forming of the light emitting pattern EP, the light emitting pattern EP may be separated by the tip portion TP formed in the barrier wall PW and may be disposed in the light emitting opening OP-E (refer to FIG. 9I) and the barrier wall opening OP-P. In the forming of the light emitting pattern EP, a first preliminary dummy pattern D1-I may be formed on the barrier wall PW and may be spaced apart from the light emitting pattern EP.

In an embodiment, in the forming of the cathode CE, the cathode CE may be separated by the tip portion TP formed in the barrier wall PW and may be disposed in the barrier wall opening OP-P. The cathode CE may be provided with an incident angle higher than that of the light emitting pattern EP, and the cathode CE may be formed to be in contact with the first inner side surface SL1 of the first barrier wall layer L1. In the forming of the cathode CE, a second preliminary dummy pattern D2-I may be formed on the barrier wall PW and may be spaced apart from the cathode CE. The anode AE, the light emitting pattern EP, and the cathode CE may form the light emitting element ED.

In an embodiment, in the forming of the capping pattern CP, the capping pattern CP may be separated by the tip portion TP formed in the barrier wall PW and may be disposed in the barrier wall opening OP-P. In the forming of the capping pattern CP, a third preliminary dummy pattern D3-I may be formed on the barrier wall PW and may be spaced apart from the capping pattern CP. Meanwhile, according to an embodiment, the forming of the capping pattern CP may be omitted.

In an embodiment, the first, second, and third preliminary dummy patterns D1-I, D2-I, and D3-I, respectively, may form a preliminary dummy pattern DMP-I, and the dummy opening OP-D may be formed through the preliminary dummy pattern DMP-I. The dummy opening OP-D may be provided with the first area AA1, the second area AA2, and the third area AA3, which are sequentially defined in the thickness direction i.e., the third direction DR3. The first area AA1 of the dummy opening OP-D may be defined by an inner side surface of the first dummy pattern D1-I, the second area AA2 may be defined by an inner side surface of the second dummy pattern D2-I, and the third area AA3 may be defined by an inner side surface of the third dummy pattern D3-I.

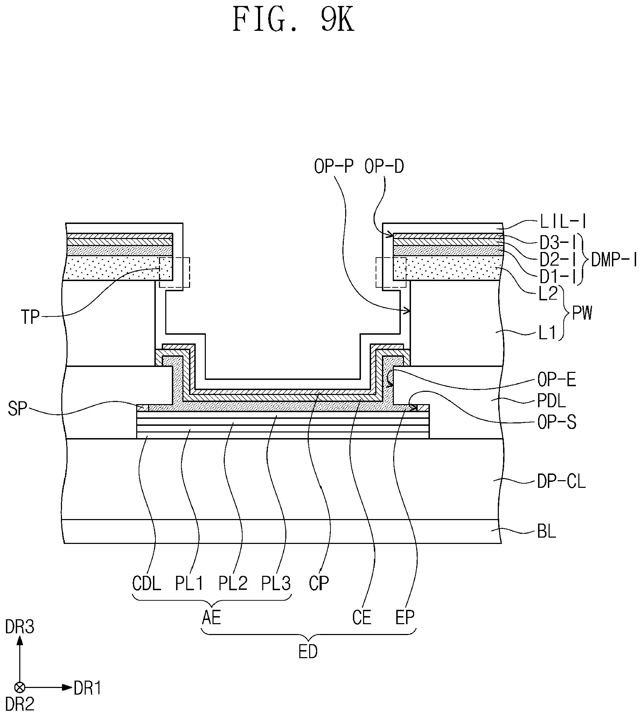

In an embodiment and referring to FIG. 9K, the manufacturing method of the display panel may include forming a preliminary lower encapsulation inorganic pattern LIL-I. The preliminary lower encapsulation inorganic pattern LIL-I may be formed by a deposition process. According to an embodiment, the preliminary lower encapsulation inorganic pattern LIL-I may be formed by a chemical vapor deposition (CVD) process. The preliminary lower encapsulation inorganic pattern LIL-I may be formed on the barrier wall PW and the cathode CE, and a portion of the preliminary lower encapsulation inorganic pattern LIL-I may be formed inside the barrier wall opening OP-P.

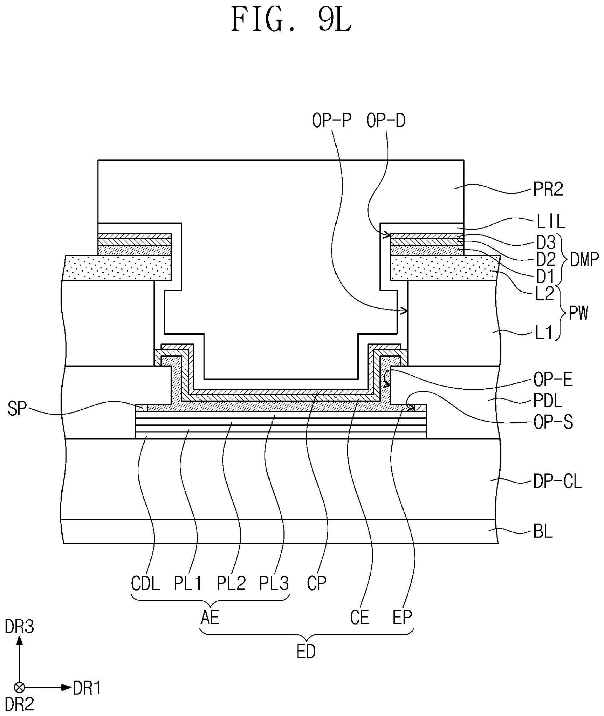

In an embodiment and referring to FIG. 9L, the manufacturing method of the display panel may include forming a second photoresist layer PR2, patterning the preliminary lower encapsulation inorganic pattern LIL-I (refer to FIG. 9K) to form the lower encapsulation inorganic pattern LIL, and patterning the preliminary dummy patterns DMP-I (refer to FIG. 9K) to form the dummy patterns DMP.

In an embodiment, in the forming of the second photoresist layer PR2, the second photoresist layer PR2 may be formed by forming a preliminary photoresist layer and patterning the preliminary photoresist layer using a photomask. The second photoresist layer PR2 may be formed in a pattern corresponding to the light emitting opening OP-E through a patterning process.

In an embodiment, the preliminary lower encapsulation inorganic pattern LIL-I (refer to FIG. 9K) may be patterned by a dry etching to remove portions of the preliminary lower encapsulation inorganic pattern LIL-I (refer to FIG. 9K), which overlap the other anodes except the corresponding anode AE. As an example, in an embodiment where the preliminary lower encapsulation inorganic pattern LIL-I (refer to FIG. 9K) corresponds to the first anode AE1 (refer to FIG. 8), portions of the preliminary lower encapsulation inorganic pattern LIL-I (refer to FIG. 9K), which overlap the second and third anodes AE2 and AE3 (refer to FIG. 8), may be removed.

In an embodiment, the lower encapsulation inorganic pattern LIL overlapping the corresponding light emitting opening OP-E may be formed from the patterned preliminary lower encapsulation inorganic pattern LIL-I (refer to FIG. 9K). A portion of the lower encapsulation inorganic pattern LIL may be disposed in the barrier wall opening OP-P to cover the light emitting element ED, and the other portion of the lower encapsulation inorganic pattern LIL may be disposed on the barrier wall PW.

In an embodiment, the preliminary dummy patterns DMP-I (refer to FIG. 9K) may be patterned to allow portions of the first, second, and third preliminary dummy patterns D1-I, D2-I, and D3-I (refer to FIG. 9K), respectively, which overlap the other anodes except the corresponding anode AE, to be removed by dry-etching the first, second, and third preliminary dummy patterns D1-I, D2-I, and D3-I (refer to FIG. 9K), respectively. As an example, in an embodiment where the first, second, and third preliminary dummy patterns D1-I, D2-I, and D3-I (refer to FIG. 9K), respectively, correspond to the first anode AE1 (refer to FIG. 8), the portions of the first, second, and third preliminary dummy patterns D1-I, D2-I, and D3-I (refer to FIG. 9K), respectively, which overlap the second and third anodes AE2 and AE3 (refer to FIG. 8), respectively, may be removed.

In an embodiment, the first, second, and third dummy patterns D1, D2, and D3, respectively, overlapping the corresponding light emitting opening OP-E may be formed from the patterned first, second, and third preliminary dummy patterns D1-I, D2-I, and D3-I (refer to FIG. 9K), respectively, and thus, the dummy patterns DMP including the first, second, and third dummy patterns D1, D2, and D3, respectively, may be formed. The first, second, and third dummy patterns D1, D2, and D3, respectively, may have a closed-line shape surrounding the corresponding light emitting area PXA (refer to FIG. 5) when viewed in the plane.

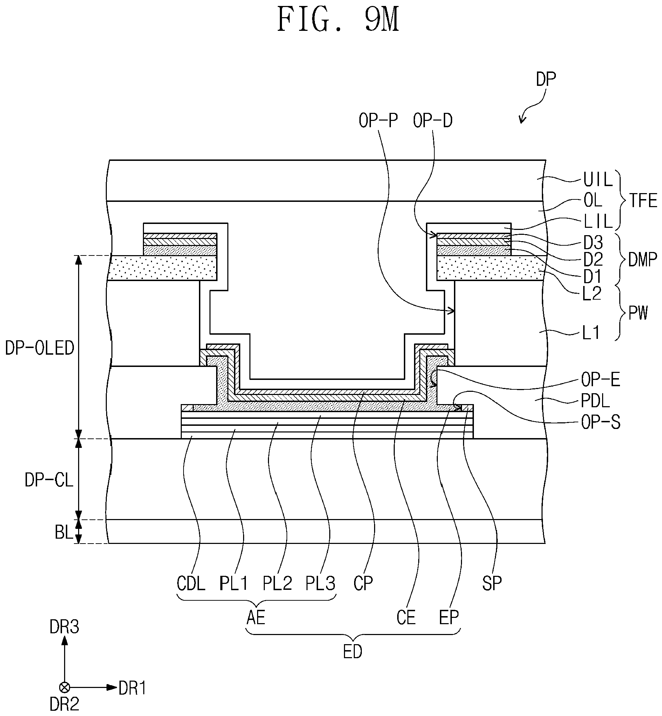

In an embodiment and referring to FIG. 9M, the manufacturing method of the display panel may include forming the encapsulation organic layer OL and the upper encapsulation inorganic layer UIL after removing the second photoresist layer PR2 (refer to FIG. 9L) to complete the display panel DP. The encapsulation organic layer OL may be formed by coating an organic material using an inkjet method, however, the invention should not be limited thereto or thereby. The encapsulation organic layer OL may provide a flat upper surface. Then, the upper encapsulation inorganic layer UIL may be formed by depositing an inorganic material. Accordingly, the display panel DP including the base layer BL, the circuit element layer DP-CL, the display element layer DP-OLED, and the thin film encapsulation layer TFE may be formed.

In an embodiment, the manufacturing method of the display panel may further include forming barrier wall openings and light emitting openings, which correspond to light emitting areas emitting other color lights, through the barrier wall PW and the pixel definition layer PDL, forming light emitting elements providing other colors, and forming a lower encapsulation inorganic pattern covering the light emitting elements providing other colors, which are performed between the forming of the lower encapsulation inorganic pattern LIL and the completing of the display panel DP. Therefore, the display panel DP including the first, second, and third light emitting elements ED1, ED2, and ED3, respectively, the first, second, and third capping patterns CP1, CP2, and CP3, respectively, the first-first, first-second, and first-third dummy patterns D1-1, D1-2, and D1-3, respectively, the second-first, second-second, and second-third dummy patterns D2-1, D2-2, and D2-3, respectively, the third-first, third-second, and third-third dummy patterns D3-1, D3-2, and D3-3, respectively, and the first, second, and third lower encapsulation inorganic patterns LIL1, LIL2, and LIL3, respectively, may be formed as shown in FIG. 8.

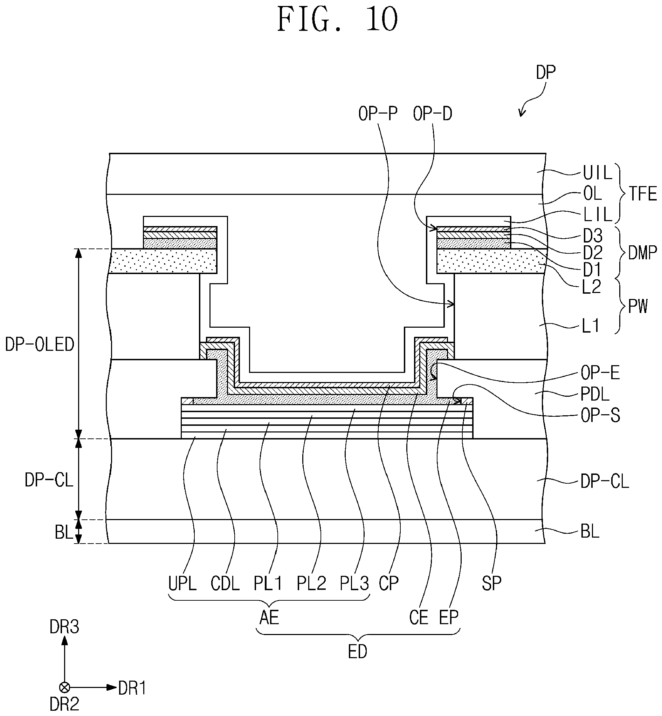

FIG. 10 is a cross-sectional view of a portion of a display panel DP according to an embodiment. In detail, FIG. 10 shows a cross-section of a portion of the display panel DP including an anode that further includes a lower protective layer UPL according to an embodiment.

In an embodiment, the display panel shown in FIG. 10 may also be formed through the processes shown in FIGS. 9A to 9M.

Referring to FIG. 10, the anode AE of the display panel DP according to an embodiment may further include the lower protective layer UPL. As described with reference to FIG. 7A, the lower protective layer UPL may be disposed between a circuit element layer DP-CL and a conductive layer CDL and may tightly adhere the conductive layer CDL to the circuit element layer DP-CL. As an example, the lower protective layer may include indium tin oxide (ITO).

Although the embodiments of the invention have been described, it is understood that the invention should not be limited to these embodiments but various changes and modifications can be made by one of ordinary skilled in the art within the scope of the present disclosure as hereinafter described. Therefore, the invention should not be limited to any single embodiment described herein, and the scope of the invention shall be determined according to the description and the attached claims. Moreover, the embodiments or parts of the embodiments may be combined in whole or in part without departing from the scope of the invention.

Embodiments are set out in the following clauses:
Clause 1. A display panel comprising: a base layer; a pixel definition layer disposed on the base layer and including a light emitting opening defined therethrough; a barrier wall disposed on the pixel definition layer, having a conductivity, and including a barrier wall opening defined therethrough to correspond to the light emitting opening; and a light emitting element disposed in the light emitting opening and comprising an anode, an intermediate layer disposed on the anode, and a cathode disposed on the intermediate layer and connected to the barrier wall, the anode comprising: a conductive layer; and a protective layer comprising a first layer, a second layer, and a third layer disposed on the conductive layer and sequentially stacked, wherein the second layer has an amorphous structure, and the third layer has a polycrystalline structure.
Clause 2. The display panel of clause 1, wherein the second layer comprises zinc indium tin oxide.
Clause 3. The display panel of clause 1, wherein the second layer comprises at least one of indium zinc oxide or indium gallium zinc oxide.
Clause 4. The display panel of clause 1, wherein the anode further comprises a lower protective layer that is in contact with a rear surface of the conductive layer, wherein the conductive layer comprises silver (Ag), and wherein the lower protective layer comprises indium tin oxide (ITO).
Clause 5. The display panel of clause 1, further comprising a sacrificial pattern disposed on the protective layer and including a sacrificial opening defined therethrough to correspond to the light emitting opening.
Clause 6. The display panel of clause 1, wherein the first layer has the polycrystalline structure.
Clause 7. The display panel of clause 6, wherein the first layer and the third layer comprise indium tin oxide (ITO).
Clause 8. The display panel of clause 6, wherein the first layer has a thickness smaller than a thickness of the third layer.
Clause 9. The display panel of clause 6, wherein a thickness of the first layer is between about 70 angstroms and about 115 angstroms, the second layer has a thickness which is between about 100 angstroms and about 500 angstroms, and the third layer has a thickness which is between about 100 angstroms and about 700 angstroms.
Clause 10. The display panel of clause 1, wherein the second layer is in contact with the intermediate layer.
Clause 11. The display panel of clause 10, wherein the second layer comprises a hole injection layer.
Clause 12. The display panel of clause 1, wherein the barrier wall has an undercut shape when viewed in a cross-section, and wherein the cathode is in contact with the barrier wall.
Clause 13. A display panel comprising: a base layer; a pixel definition layer disposed on the base layer and including a light emitting opening defined therethrough; a barrier wall disposed on the pixel definition layer, the barrier wall having a conductivity, including a barrier wall opening defined therethrough to overlap the light emitting opening, and having an undercut shape; and a light emitting element comprising an anode disposed in the barrier wall opening, at least a portion of the anode being covered by the pixel definition layer, a cathode disposed above the anode and connected to the barrier wall, and an intermediate layer disposed between the anode and the cathode and comprising a light emitting layer, the anode comprising: a conductive layer; a first protective layer disposed on the conductive layer and having an amorphous structure; and a second protective layer disposed on the first protective layer and having a polycrystalline structure.
Clause 14. The display panel of clause 13, wherein the first protective layer comprises indium tin oxide (ITO), and the second protective layer comprises zinc indium tin oxide (ZITO).
Clause 15. The display panel of clause 13, wherein the first protective layer has a thickness which is between about 100 angstroms and about 500 angstroms, and the second protective layer has a thickness which is between about 100 angstroms and about 700 angstroms.
Clause 16. A method of manufacturing a display panel, comprising: forming a preliminary anode pattern comprising a conductive layer and a protective layer comprising a first layer, a second layer, and a third layer sequentially disposed on the conductive layer and having an amorphous structure; heat treating the preliminary anode pattern to form an anode pattern having a first anode pattern layer, a second anode pattern layer and a third anode pattern layer; forming an insulating layer; patterning the insulating layer to form a pixel definition layer through which a plurality of light emitting openings is formed to expose at least a portion of the anode pattern; forming a conductive layer on the pixel definition layer; and forming a barrier wall opening corresponding to the light emitting opening through the conductive layer to form a barrier wall having an undercut shape, wherein the second layer has a same crystalline structure as a second layer of the anode pattern in the heat treating of the preliminary anode pattern.
Clause 17. The method of clause 16, wherein the heat treating of the preliminary anode pattern is carried out within a temperature range between about 200 degrees Celsius and about 260 degrees Celsius.
Clause 18. The method of clause 16, wherein the first anode pattern layer and the anode pattern third layer have a polycrystalline structure.
Clause 19. The method of clause 16, wherein a gas containing argon (Ar) and hydrogen (H2) is used in the forming of the third layer.
Clause 20. The method of clause 16, wherein the forming of the barrier wall comprises: forming a first conductive layer on the pixel definition layer; forming a second conductive layer on the first conductive layer; first etching the first and second conductive layers to form a first pattern; and second etching the first pattern to form an undercut shape in the first pattern.
Clause 21. The method of clause 20, wherein a first etchant used in the first etching is different from a second etchant used in the second etching.
Clause 22. The method of clause 20, further comprising forming an intermediate layer comprising a light emitting material and a cathode that is in contact with the barrier wall in the barrier wall opening.

## Claims

1. A display panel comprising:
a base layer;
a pixel definition layer disposed on the base layer and including a light emitting opening defined therethrough;
a barrier wall disposed on the pixel definition layer, having a conductivity, and including a barrier wall opening defined therethrough to correspond to the light emitting opening; and
a light emitting element disposed in the light emitting opening and comprising an anode, an intermediate layer disposed on the anode, and a cathode disposed on the intermediate layer and connected to the barrier wall, the anode comprising:
a conductive layer; and
a protective layer comprising a first layer, a second layer, and a third layer disposed on the conductive layer and sequentially stacked, wherein the second layer has an amorphous structure, and the third layer has a polycrystalline structure.

2. The display panel of claim 1, wherein at least one of:
the second layer comprises zinc indium tin oxide;
the second layer comprises indium zinc oxide;
the second layer comprises indium gallium zinc oxide; and
the first layer and the third layer comprise indium tin oxide (ITO).

3. The display panel of claim 1 or 2, wherein the anode further comprises a lower protective layer that is in contact with a rear surface of the conductive layer, wherein the conductive layer comprises silver (Ag), and wherein the lower protective layer comprises indium tin oxide (ITO).

4. The display panel of claim 1, 2 or 3, further comprising a sacrificial pattern disposed on the protective layer and including a sacrificial opening defined therethrough to correspond to the light emitting opening.

5. The display panel of any preceding claim, wherein the first layer has the polycrystalline structure.

6. The display panel of any preceding claim, wherein at least one of:
the first layer has a thickness smaller than a thickness of the third layer;
a thickness of the first layer is between about 70 angstroms and about 115 angstroms, the second layer has a thickness which is between about 100 angstroms and about 500 angstroms, and the third layer has a thickness which is between about 100 angstroms and about 700 angstroms.

7. The display panel of any preceding claim, wherein at least one of:
the second layer is in contact with the intermediate layer;
the second layer comprises a hole injection layer.

8. The display panel of any preceding claim, wherein the barrier wall has an undercut shape when viewed in a cross-section, and wherein the cathode is in contact with the barrier wall.

9. A display panel comprising:
a base layer;
a pixel definition layer disposed on the base layer and including a light emitting opening defined therethrough;
a barrier wall disposed on the pixel definition layer, the barrier wall having a conductivity, including a barrier wall opening defined therethrough to overlap the light emitting opening, and having an undercut shape; and
a light emitting element comprising an anode disposed in the barrier wall opening, at least a portion of the anode being covered by the pixel definition layer, a cathode disposed above the anode and connected to the barrier wall, and an intermediate layer disposed between the anode and the cathode and comprising a light emitting layer, the anode comprising:
a conductive layer;
a first protective layer disposed on the conductive layer and having an amorphous structure; and
a second protective layer disposed on the first protective layer and having a polycrystalline structure.

10. The display panel of claim 9, wherein at least one of:
the first protective layer comprises indium tin oxide (ITO), and the second protective layer comprises zinc indium tin oxide (ZITO); and
the first protective layer has a thickness which is between about 100 angstroms and about 500 angstroms, and the second protective layer has a thickness which is between about 100 angstroms and about 700 angstroms.

11. A method of manufacturing a display panel, comprising:
forming a preliminary anode pattern comprising a conductive layer and a protective layer comprising a first layer, a second layer, and a third layer sequentially disposed on the conductive layer and having an amorphous structure;
heat treating the preliminary anode pattern to form an anode pattern having a first anode pattern layer, a second anode pattern layer and a third anode pattern layer;
forming an insulating layer;
patterning the insulating layer to form a pixel definition layer through which a plurality of light emitting openings is formed to expose at least a portion of the anode pattern;
forming a conductive layer on the pixel definition layer; and
forming a barrier wall opening corresponding to the light emitting opening through the conductive layer to form a barrier wall having an undercut shape, wherein the second layer has a same crystalline structure as a second layer of the anode pattern in the heat treating of the preliminary anode pattern.

12. The method of claim 11, wherein at least one of:
the heat treating of the preliminary anode pattern is carried out within a temperature range between about 200 degrees Celsius and about 260 degrees Celsius; and
a gas containing argon (Ar) and hydrogen (H2) is used in the forming of the third layer.

13. The method of claim 11 or 12, wherein the first anode pattern layer and the anode pattern third layer have a polycrystalline structure.

14. The method of any one of claims 11, 12 or 13, wherein the forming of the barrier wall comprises:
forming a first conductive layer on the pixel definition layer;
forming a second conductive layer on the first conductive layer;
first etching the first and second conductive layers to form a first pattern; and
second etching the first pattern to form an undercut shape in the first pattern,
and wherein optionally a first etchant used in the first etching is different from a second etchant used in the second etching.

15. The method of claim 14, further comprising forming an intermediate layer comprising a light emitting material and a cathode that is in contact with the barrier wall in the barrier wall opening.
